# EUROPEAN PATENT APPLICATION

(11) **EP 3 961 738 A1**
(43) Date of publication of application: **02.03.2022**
(21) Application number: 19926018.3
(22) Date of filing: 26.04.2019
(51) Int. Cl.: H01L 51/50, G09F 9/30, H01L 27/32

(54) **ORGANIC ELECTRONICS MATERIAL AND METHOD FOR PREPARING CHARGE-CARRYING POLYMER**

(71) Applicant: Showa Denko Materials Co., Ltd., Tokyo 100-6606 (JP)
(72) Inventor: KAMO Kazuyuki, Tokyo 100-6606 (JP); FUKUSHIMA Iori, Tokyo 100-6606 (JP); ISHITSUKA Kenichi, Tokyo 100-6606 (JP); MIYA Takanori, Tokyo 100-6606 (JP)
(74) Representative: Becker, Eberhard
(86) International application number: PCT/JP2019/018128
(87) International publication number: WO 2020/217520

(57) **Abstract**

An embodiment of the present invention pertains to an organic electronics material containing a charge transport polymer which includes: a structural unit represented by formula (1); at least one structural unit selected from the group consisting of a structural unit represented by formula (2-1) and a structural unit represented by formula (2-2); and a structural unit which is represented by formula (3) an of which an amount is 85-100 mol% with respect to the total amount of monovalent structural units.

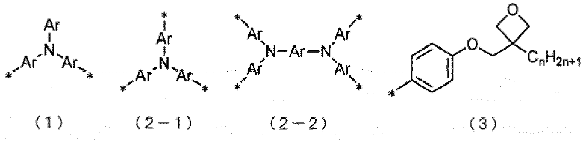

## Description

### BACKGROUND

### Technical Field

Embodiments of the present invention relate to an organic electronics material, a method for preparing a charge-transporting polymer, a liquid composition, an organic layer, an organic electronics element, an organic electroluminescence element (an organic EL element), a display element, a lighting device, and a display device.

### Related Art

Organic electronics elements are elements that perform electrical operations using organic substances, and are expected to exhibit features such as energy saving, low cost, and flexibility. Examples of the organic electronics elements include organic EL elements, organic photoelectric conversion elements, organic transistors and the like.

Further improvements are desired in various element characteristics of the organic EL elements. As an approach to improving the performance of the organic EL elements, attempts have been made to make the organic layers multi-layered and separate the functions in each layer. When the number of layers is increased according to a wet process, the solvent resistance of a lower layer to the solvent of the coating solution used for forming an upper layer is required.

In order to make the organic layer multi-layered, for example, a method of utilizing a compound having at least one polymerizable group has been studied (see Patent literature 1 for example).

### [Literature of related art]

### [Patent literature]

Patent literature 1: Japanese Patent Laid-Open No. 2006-279007

### SUMMARY

### [Problems to be Solved]

An embodiment of the present invention provides an organic electronics material and a liquid composition capable of forming an organic layer having an appropriate energy level and excellent solvent resistance and capable of improving the life characteristics of an organic electronics element. Another embodiment of the present invention provides a method for preparing a charge-transporting polymer suitable for a charge-transporting polymer used in the organic electronics material. Another embodiment of the present invention provides an organic layer having an appropriate energy level and excellent solvent resistance and capable of improving the life characteristics of an organic electronics element. Still another embodiment of the present invention provides an organic electronics element, an organic EL element, a display element, a lighting device, and a display device having improved life characteristics.

### [Means to Solve Problems]

Examples of embodiments are given below. The present invention is not limited to the following embodiments.

One embodiment relates to an organic electronics material containing a charge-transporting polymer, wherein the charge-transporting polymer comprises a structural unit represented by a formula (1) below, at least one structural unit selected from a group consisting of a structural unit represented by a formula (2-1) below and a structural unit represented by a formula (2-2) below, and 85 to 100 mol% of a structural unit represented by a formula (3) below based on a total amount of a monovalent structural unit. 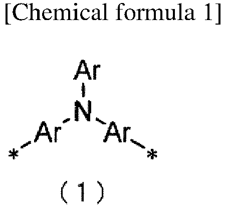 (In the formula, Ar independently represents a substituted or unsubstituted aromatic hydrocarbon group, and at least one Ar is an aromatic hydrocarbon group having a substituent comprising at least one selected from a group consisting of a fluoro group and a fluoroalkyl group.) 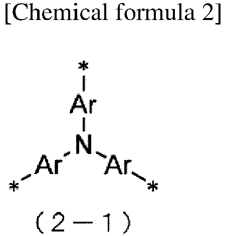 (In the formula, Ar independently represents a substituted or unsubstituted aromatic hydrocarbon group.) 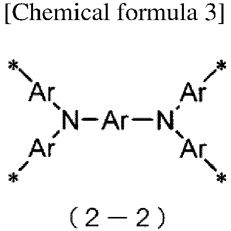 (In the formula, Ar independently represents a substituted or unsubstituted aromatic hydrocarbon group.) 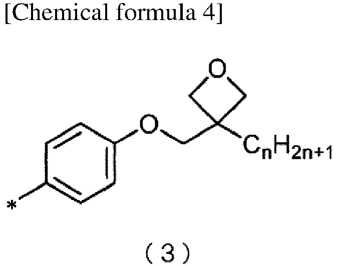 (In the formula, n represents an integer of 0 to 20.)

Another embodiment relates to a method for preparing a charge-transporting polymer which prepares a charge-transporting polymer used in the organic electronics material. The method includes making a monomer mixture react in a solvent containing an aromatic ether, wherein the monomer mixture contains a bifunctional monomer having the structural unit represented by the formula (1), at least one trifunctional or tetrafunctional monomer selected from a group consisting of a trifunctional monomer having the structural unit represented by the formula (2-1) and a tetrafunctional monomer having the structural unit represented by the formula (2-2), and 85 to 100 mol% of a monofunctional monomer having the structural unit represented by the formula (3) based on the total amount of the monofunctional monomer.

Another embodiment relates to a liquid composition containing the organic electronics material and a solvent.

Another embodiment relates to an organic layer formed using the organic electronics material or the liquid composition.

Another embodiment relates to an organic electronics element having at least one of the organic layer.

Another embodiment relates to an organic electroluminescent device having at least one of the organic layer.

Another embodiment relates to a display element including the organic electroluminescence element, a lighting device including the organic electroluminescence element, and a display device including the lighting device and a liquid crystal element as a display part.

### [Effects]

According to an embodiment of the present invention, it is possible to provide an organic electronics material and a liquid composition capable of forming an organic layer having an appropriate energy level and excellent solvent resistance and capable of improving the life characteristics of an organic electronics element. According to another embodiment of the present invention, it is possible to provide a method for preparing a charge-transporting polymer suitable for the charge-transporting polymer used in the organic electronics material. According to another embodiment of the present invention, it is possible to provide an organic layer having an appropriate energy level and excellent solvent resistance and capable of improving the life characteristics of an organic electronics element. According to still another embodiment of the present invention, it is possible to provide an organic electronics element, an organic EL element, a display element, a lighting device, and a display device having improved life characteristics.

### BRIEF DESCRIPTION OF THE DRAWINGS

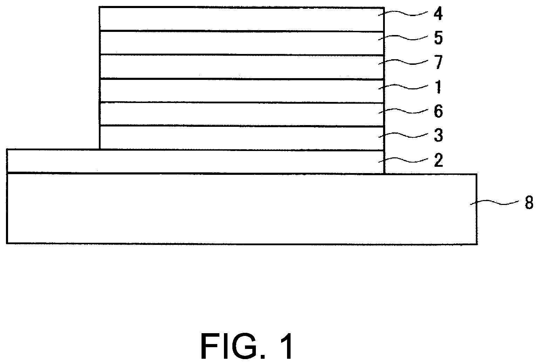

FIG. 1 is a schematic cross-sectional view showing an example of an organic EL element according to an embodiment.

### DESCRIPTION OF THE EMBODIMENTS

Embodiments of the present invention are described. The present invention is not limited to the following embodiments.

### <Organic electronics materials>

One embodiment of the present invention relates to an organic electronics material containing at least a charge-transporting polymer that comprises a structural unit represented by formula (1), at least one structural unit selected from a group consisting of a structural unit represented by formula (2-1) and a structural unit represented by formula (2-2), and 85 to 100 mol% of a structural unit represented by formula (3) based on the total amount of monovalent structural unit. The organic electronics material may further contain any component such as a dopant, a polymerization initiator and the like.

In the present disclosure, the "structural unit represented by formula (X)" may be referred to as the "structural unit (X)". In addition, "at least one structural unit selected from a group consisting of a structural unit represented by formula (Y-1) and a structural unit represented by formula (Y-2)" may be referred to as "structural unit (Y)".

### [Charge-transporting polymer]

The charge-transporting polymer comprises at least the structural unit (1), the structural unit (2) and the structural unit (3). The content of the structural unit (3) is 85 to 100 mol% based on the total amount of the monovalent structural unit. The charge-transporting polymer may further comprise any structural unit different from the structural units (1) to (3). For example, the charge-transporting polymer may further contain at least one structural unit selected from a group consisting of a structural unit represented by formula (4-1) and a structural unit represented by formula (4-2).

### (Structural unit (1))

The charge-transporting polymer comprises a structural unit (1). The structural unit (1) is a divalent structural unit having two binding sites with other structural units. By comprising the structural unit (1), an organic layer having an appropriate energy level can be formed. The charge-transporting polymer may comprise only one type of the structural unit (1) or may comprise two or more types.

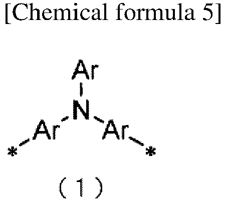

In the formula, Ar independently represents a substituted or unsubstituted aromatic hydrocarbon group, and at least one Ar is an aromatic hydrocarbon group having a substituent comprising at least one group selected from a group consisting of a fluoro group and a fluoroalkyl group.

In the present disclosure, "*" in the structural formula represents a binding site with another structural unit or structure.

An aromatic hydrocarbon group is an atomic group obtained by removing one or two hydrogen atoms from an aromatic hydrocarbon. The number of carbon atoms of the aromatic hydrocarbon group is preferably 6 to 30, more preferably 6 to 14, and further preferably 6 to 10. Examples of the aromatic hydrocarbon include benzene, naphthalene, anthracene, tetracene, fluorene, phenanthrene, 9,10-dihydrophenanthrene, triphenylene, pyrene, chrycene, perylene, triphenylene, pentacene, benzopyrene and the like.

Ar is preferably a substituted or unsubstituted benzene group, a substituted or unsubstituted naphthalene group, or a substituted or unsubstituted anthracene group, respectively, and is more preferably a substituted or unsubstituted benzene group, or a substituted or unsubstituted naphthalene group.

The aromatic hydrocarbon group may have a substituent. The substituent may be, for example, a substituent selected from a group consisting of -R¹, -OR², -SR³, -OCOR⁴, -COOR⁵, -SiR⁶R⁷R⁸ and a halogen atom (hereinafter, may be referred to as "substituent Ra").

R¹ is selected from a group consisting of an alkyl group, an aryl group and a heteroaryl group. R² to R⁸ is independently selected from a group consisting of a hydrogen atom, an alkyl group, an aryl group and a heteroaryl group. The halogen atom may be a fluorine atom, a chlorine atom, a bromine atom and an iodine atom.

The alkyl group may be linear, branched or cyclic. The alkyl group preferably has 1 to 22 carbon atoms. The aryl group preferably has 6 to 30 carbon atoms. The heteroaryl group preferably has 2 to 30 carbon atoms. The alkyl group, the aryl group and the heteroaryl group may be substituted or unsubstituted.

Examples of the substituent when the alkyl group, the aryl group and the heteroaryl group have a substituent include the substituent Ra and is preferably -R¹. Examples of the alkyl group having a substituent include an arylalkyl group, a heteroarylalkyl group, a fluoroalkyl group and the like. Examples of the aryl group having a substituent include an alkylaryl group, a fluoroaryl group and the like. Examples of the heteroaryl group having a substituent include an alkyl heteroaryl group and the like.

The alkyl group may be, for example, methyl group, ethyl group, n-propyl group, n-butyl group, n-pentyl group, n-hexyl group, n-heptyl group, n-octyl group, n-nonyl group, n-decyl group, n-undecyl group, n-dodecyl group, isopropyl group, isobutyl group, sec-butyl group, tert-butyl group, 2-ethylhexyl group, 3,7-dimethyloctyl group, cyclohexyl group, cycloheptyl group, cyclooctyl group and the like.

In the present disclosure, the aryl group is an atomic group obtained by removing one hydrogen atom from an aromatic hydrocarbon. The heteroaryl group is an atomic group obtained by removing one hydrogen atom from an aromatic heterocyclic compound. The aromatic hydrocarbon here may be a monocyclic ring, a condensed ring, or a polycyclic ring in which two or more rings selected from a monocyclic ring and a condensed ring are directly bonded via a direct bond. The aromatic heterocyclic compound here may be a monocyclic ring, a condensed ring, or a polycyclic ring in which two or more rings selected from a monocyclic ring and a condensed ring are directly bonded via a direct bond.

Examples of the aromatic hydrocarbon in the aryl group include benzene, naphthalene, anthracene, tetracene, fluorene, phenanthrene, 9,10-dihydrophenanthrene, triphenylene, pyrene, chrysen, perylene, triphenylene, pentacene, benzopyrene, biphenyl, terphenyl, triphenylbenzene and the like. Examples of the aromatic heterocyclic compounds in the heteroaryl group include pyridine, pyrazine, quinoline, isoquinoline, aclysine, phenanthroline, carbazole, furan, benzofuran, dibenzofuran, pyrrole, thiophene, benzothiophene, dibenzothiophene, oxazole, oxadiazol, thiadiazole, triazole, benzoxazole, benzoxadiazole, benzothiadiazole, benzotriazole, benzothiophene, bithiophene and the like.

In formula (1), at least one Ar is an aromatic hydrocarbon group having a substituent containing at least one group selected from a group consisting of a fluoro group and a fluoroalkyl group. The fluoroalkyl group preferably has 1 to 4 carbon atoms, more preferably 1 or 2 carbon atoms. The fluoroalkyl group is preferably a perfluoroalkyl group.

For example, from the viewpoint of achieving both a deep HOMO level and a large energy gap between HOMO and LUMO, it is preferable that at least one Ar is an aromatic hydrocarbon group having a fluoro group and all of Ar are aromatic hydrocarbon groups having no fluoroalkyl group in the structural unit (1).

On the other hand, for example, from the viewpoint of obtaining a deeper HOMO level, it is preferable that at least one Ar is an aromatic hydrocarbon group having a fluoroalkyl group in the structural unit (1).

The number of the fluoro group or the fluoroalkyl group contained in the structural unit (1) is preferably 1 to 8, more preferably 1 to 6, further preferably 1 to 4, and particularly preferably 1 to 3. In the case of the above number, the effect of deepening the HOMO level tends to be easily obtained. In addition, in the case of the above number, it tends to be easy to prevent the charge-transporting polymer from becoming too low in solubility.

The structural unit (1) preferably comprises, for example, the following structural unit (1a).

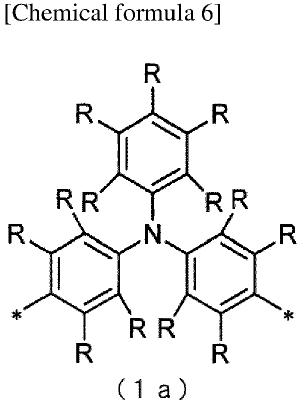

In the formula, R independently represents a hydrogen atom or a substituent, and at least one R is a fluoro group or a fluoroalkyl group.

The fluoroalkyl group preferably has 1 to 4 carbon atoms, more preferably 1 or 2 carbon atoms. The fluoroalkyl group is preferably a perfluoroalkyl group. In the formula, the number of R which is a fluoro group or a fluoroalkyl group is preferably 1 to 8, more preferably 1 to 6, further preferably 1 to 4, and particularly preferably 1 to 3.

The R which is not a fluoro or fluoroalkyl group is a hydrogen atom or a substituent. Examples of the substituent include the substituent Ra (however, the fluoro group and the fluoroalkyl group are excluded here). From the viewpoint of suppressing the influence of the substituent, all Rs that are not fluoro groups or fluoroalkyl groups may be hydrogen atoms.

The structural unit (1) preferably comprises, for example, at least one structural unit selected from a group consisting of the following structural units (1b) to (1e).

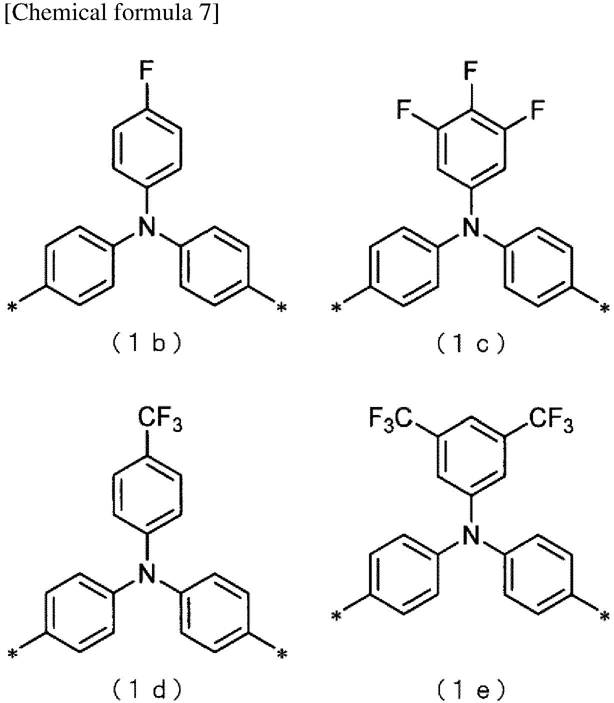

When the charge-transporting polymer comprises the structural unit (1b) and/or the structural unit (1c), deep HOMO levels and a large energy gap between HOMO and LUMO tend to be easily obtained. When the charge-transporting polymer comprises a structural unit (1d) and/or a structural unit (1e), a deeper HOMO level tends to be easily obtained. When the charge-transporting polymer comprises the structural unit (1e), good solubility of the charge-transporting polymer tends to be easily obtained.

### (Structural unit (2))

The charge-transporting polymer comprises at least one structural unit (2) selected from a group consisting of a structural unit (2-1) and a structural unit (2-2). The structural unit (2-1) is a trivalent structural unit having three binding sites with other structural units. The structural unit (2-2) is a tetravalent structural unit having four binding sites with other structural units. The structural unit (2) is a trivalent or tetravalent structural unit having three or four binding sites with other structural units. By comprising the structural unit (2), the charge-transporting polymer becomes a branched polymer and becomes a polymer having three or more ends in one molecule. The branched polymer can easily increase the molecular weight thereof and tends to exhibit good solubility. The charge-transporting polymer may comprise only one type of the structural unit (2) or may comprise two or more types.

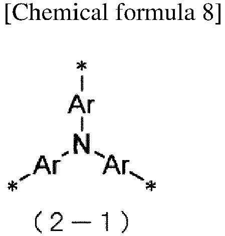

In the formula, Ar independently represents a substituted or unsubstituted aromatic hydrocarbon group.

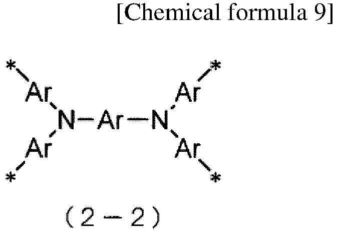

In the formula, Ar independently represents a substituted or unsubstituted aromatic hydrocarbon group.

As for the substituted or unsubstituted aromatic hydrocarbon group, the description regarding the substituted or unsubstituted aromatic hydrocarbon group in the structural unit (1) can be applied. Ar is preferably an unsubstituted aromatic hydrocarbon group.

In the structural unit (2-1), Ar is preferably a substituted or unsubstituted benzene group, a substituted or unsubstituted naphthalene group, or a substituted or unsubstituted anthracene group, respectively, more preferably a substituted or unsubstituted benzene group or a substituted or unsubstituted naphthalene group, and further preferably a substituted or unsubstituted benzene group.

In the structural unit (2-2), Ar is preferably a substituted or unsubstituted benzene group, a substituted or unsubstituted naphthalene group, or a substituted or unsubstituted anthracene group, respectively, more preferably a substituted or unsubstituted benzene group or a substituted or unsubstituted naphthalene group, and further preferably a substituted or unsubstituted benzene group.

The structural unit (2) preferably comprises, for example, at least one structural unit selected from a group consisting of the following structural unit (2-1a), the following structural unit (2-1b), and the following structural unit (2-2a).

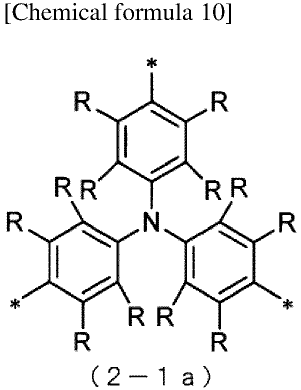

In the formula, R independently represents a hydrogen atom or a substituent. Examples of the substituent include the substituent Ra.

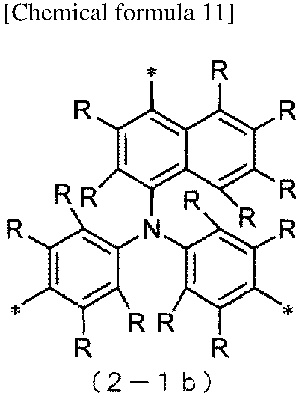

In the formula, R independently represents a hydrogen atom or a substituent. Examples of the substituent include the substituent Ra.

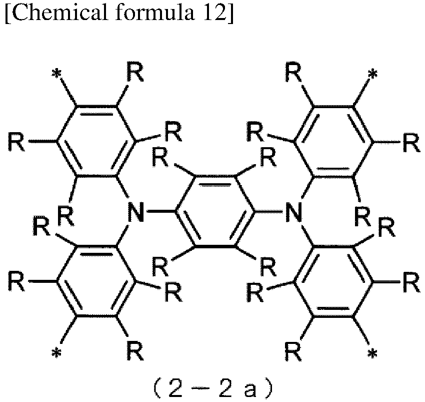

In the formula, R independently represents a hydrogen atom or a substituent. Examples of the substituent include the substituent Ra.

The structural unit (2) preferably comprises, for example, at least one structural unit selected from a group consisting of the following structural units (2-1c), (2-1d), and (2-2b).

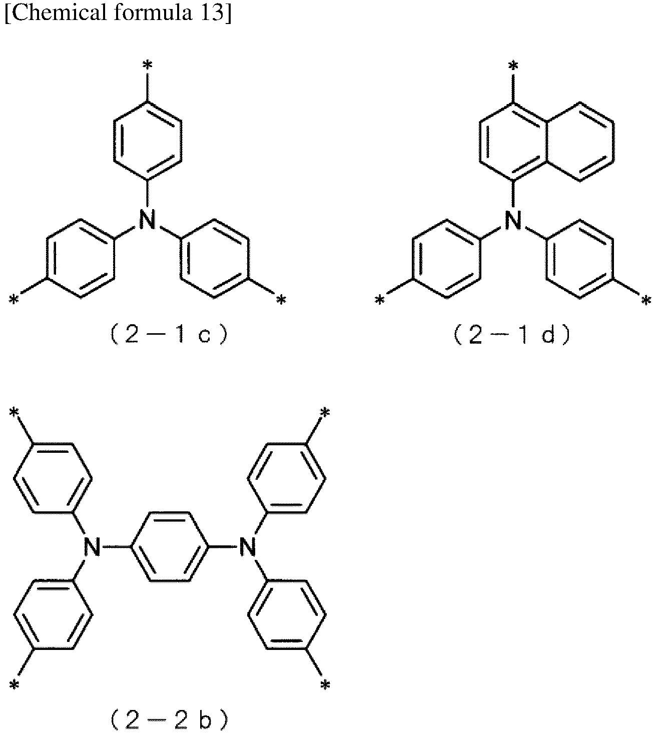

### (Structural unit (3))

The charge-transporting polymer comprises a structural unit (3). The structural unit (3) is a monovalent structural unit having one binding site with another structural unit. The structural unit (3) is contained at the end of the polymer chain of the charge-transporting polymer. The content of the structural unit (3) is 85 to 100 mol% based on the total amount of the monovalent structural unit forming the end portion. By comprising 85 to 100 mol% of the structural unit (3), an organic layer having excellent solvent resistance can be obtained, and the life characteristics of the organic electronics element can be improved. The charge-transporting polymer may comprise only one type of structural unit (3) or two or more types.

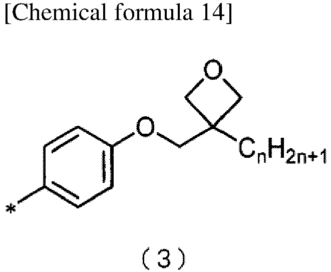

In the formula, n represents an integer from 0 to 20.

From the viewpoint of improving reactivity and life characteristics, n is preferably 1 to 8, more preferably 1 to 6, further preferably 1 to 3, and particularly preferably 1 or 2.

The structural unit (3) is a structural unit represented by "*-Ph-O-CH₂-OXT-CₙH₂ₙ₊₁" (Ph is a phenylene group, OXT is an oxetane group, and the same applies hereinafter). Because the structural unit exhibits excellent reactivity due to the above-mentioned structure comprising an oxetane group, the curing reaction of the charge-transporting polymer can be efficiently advanced. The above structural unit is more preferable than a structural unit comprising "*-Ph-CH₂-*" or "*-Ph-CH₂-O-CH₂-*" in that a charge-transporting polymer having better heat resistance is obtained. The above structural unit is more preferable than a structural unit comprising "*-(CH₂)ₙ-(n is an integer greater than or equal to 2)*" between "*-Ph-*" and "*-OXT-CₙH₂ₙ₊₁" in that an organic electronics element exhibiting better life characteristics is obtained.

The content of the structural unit (3) is 85 to 100 mol% based on the total amount of the monovalent structural unit. When the content is 85 mol% or more, an organic layer having excellent solvent resistance can be obtained, and the life characteristics of the organic electronics element can be improved. Because these higher effects tend to be obtained, the content of the structural unit (3) is preferably 90 mol% or more, and more preferably 95 mol% or more. The upper limit of the content of the structural unit (3) is 100 mol%. When a structural unit having another function is introduced at the end of the charge-transporting polymer, the content of the structural unit (3) may be less than 100 mol%, for example, 95 mol% or less or 90 mol% or less.

The structural unit (3) preferably comprises, for example, the following structural unit (3a).

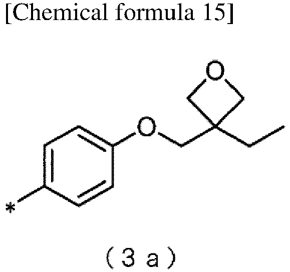

### (Structural unit (4))

The charge-transporting polymer may comprise at least one structural unit (4) selected from a group consisting of a structural unit (4-1) and a structural unit (4-2). The structural unit (4-1), the structural unit (4-2), and the structural unit (4) are monovalent structural units having one binding site with another structural unit. The structural unit (4) is contained at the end portion of the polymer chain of the charge-transporting polymer. The content of the structural unit (4) is preferably 0 to 15 mol% based on the total amount of the monovalent structural unit forming the end portion. By comprising the structural unit (4), the solubility of the charge-transporting polymer tends to improve. The charge-transporting polymer may comprise only one type of the structural unit (4) or two or more types.

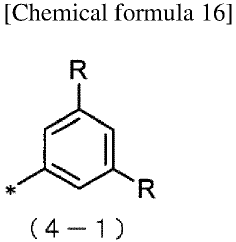

In the formula, R is independently a halogen group, a halogen-substituted alkyl group, a nitro group, a cyano group, a substituted or unsubstituted sulfo group (-S(O₂)-OR' (R' is a hydrogen atom or a hydrocarbon group)) or a substituted or unsubstituted sulfino group (-S(O)-OR' (R'is a hydrogen atom or a hydrocarbon group)).

The halogen group is preferably a fluoro group. The halogen-substituted alkyl group preferably has 1 to 4 carbon atoms, and more preferably 1 or 2 carbon atoms. The halogen-substituted alkyl group is preferably a fluoroalkyl group. The fluoroalkyl group is preferably a perfluoroalkyl group. Each R' in the sulfo group and the sulfino group is preferably a hydrogen atom or an alkyl group, and when each R' is an alkyl group, the number of carbon atoms is preferably 1 to 4.

The two Rs may be the same or different from each other and are preferably the same as each other. Each R is preferably a fluoro group or a fluoroalkyl group, more preferably a fluoroalkyl group, and further preferably a perfluoroalkyl group having 1 to 4 carbon atoms.

When the charge-transporting polymer comprises the structural unit (4-1), a deeper HOMO level tend to be easily obtained.

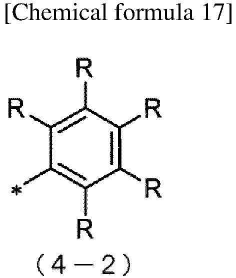

In the formula, R independently represents a hydrogen atom or a linear alkyl group, and at least one R is a linear alkyl group.

The linear alkyl group preferably has 4 to 20 carbon atoms, more preferably 4 to 16 carbon atoms, and further preferably 4 to 12 carbon atoms.

The content of the structural unit (4) is 0 to 15 mol% based on the total amount of the monovalent structural unit. That is, the charge-transporting polymer does not comprise the structural unit (4) (0 mol%), or when the charge-transporting polymer comprises the structural unit (4), the content of the structural unit (4) is 15 mol% or less. When the content is 15 mol% or less, the content of the structural unit (3) is sufficient, and an organic layer having excellent solvent resistance can be obtained. In addition, it is possible to obtain the effect of preventing the large energy gap between HOMO and LUMO from becoming smaller or the effect of improving the life characteristics of the organic electronics element. Because these higher effects tend to be obtained, the content of the structural unit (4) is preferably 10 mol% or less, more preferably 7 mol% or less, and further preferably 5 mol% or less. The lower limit of the content of the structural unit (4) is 0 mol%. When it is desired to improve the solubility of the charge-transporting polymer, the content of the structural unit (4) may be more than 0 mol%, for example, 5 mol% or more or 10 mol% or more.

The structural unit (4) preferably comprises, for example, at least one structural unit selected from a group consisting of the following structural units (4-1a) and (4-2a).

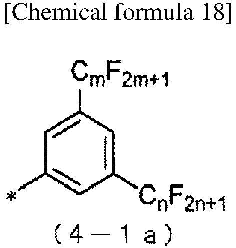

In the formula, n and m each independently represent an integer of 1 to 4. n and m may be the same or different from each other, and are preferably the same.

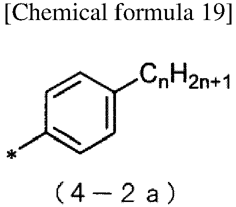

In the formula, n represents an integer of 4 to 20. n is more preferably 4 to 16, and further preferably 4 to 12.

The structural unit (4) preferably comprises, for example, at least one structural unit selected from a group consisting of the following structural units (4-1b) and (4-2b).

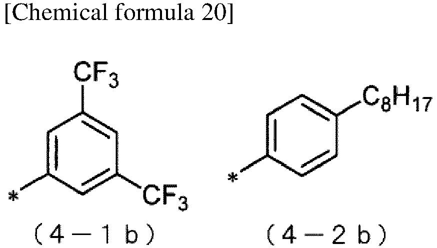

### (Optional structural unit)

The charge-transporting polymer may further contain an optional structural unit different from the structural units (1) to (3) (hereinafter, referred to as "optional structural unit"). The optional structural unit may be, for example, the structural unit (4).

In addition, the optional structural unit may be, for example, a substituted or unsubstituted aromatic amine structure, a substituted or unsubstituted carbazole structure, a substituted or unsubstituted thiophene structure, a substituted or unsubstituted fluorene structure, a substituted or unsubstituted benzene structure, a substituted or unsubstituted biphenyl structure, a substituted or unsubstituted terphenyl structure, a substituted or unsubstituted naphthalene structure, a substituted or unsubstituted anthracene structure, a substituted or unsubstituted tetracene structure, a substituted or unsubstituted phenanthrene structure, a substituted or unsubstituted dihydrophenanthrene structure, a substituted or unsubstituted pyridine structure, a substituted or unsubstituted pyrazine structure, a substituted or unsubstituted quinoline structure, a substituted or unsubstituted isoquinolin structure, a substituted or unsubstituted quinoxalin structure, a substituted or unsubstituted aclydin structure, a substituted or unsubstituted diazaphenanthrene structure, a substituted or unsubstituted furan structure, a substituted or unsubstituted pyrrole structure, a substituted or unsubstituted oxazole structure, a substituted or unsubstituted oxadiazole structure, a substituted or unsubstituted thiazole structure, a substituted or unsubstituted thiadiazole structure, a substituted or unsubstituted triazole structure, a substituted or unsubstituted benzothiophene structure, a substituted or unsubstituted benzoxazole structure, a substituted or unsubstituted benzoxadiazole structure, a substituted or unsubstituted benzothiazole structure, a substituted or unsubstituted benzothiadiazole structure, a substituted or unsubstituted benzotriazole structure, and a structure comprising one or more of the above structures.

The optional structural unit may be monovalent or higher valent, preferably monovalent to hexavalent, more preferably monovalent to pentavalent, and further preferably monovalent to tetravalent.

The description of the substituent in the structural unit (1) can be applied to the substituent contained in the optional structural unit.

### (Content of each structural unit)

The charge-transporting polymer may comprise a divalent structural unit in addition to the structural unit (1). From the viewpoint of adjusting the energy level, the content of the structural unit (1) is preferably 50 mol% or more, more preferably 75 mol% or more, and further preferably 90 mol% or more based on the total amount of the divalent structural unit. The upper limit of the content of the structural unit (1) is 100 mol%.

From the viewpoint of obtaining sufficient charge-transporting property, the content of the divalent structural unit contained in the charge-transporting polymer is preferably 10 mol% or more, more preferably 15 mol% or more, and further preferably 20 mol% or more based on all the structural units. In addition, considering the monovalent structural unit and the trivalent or higher valent structural unit, the content of the divalent structural unit is preferably 95 mol% or less, more preferably 90 mol% or less, and further preferably 85 mol% or less.

The charge-transporting polymer may comprise a structural unit having a valence of 3 or more in addition to the structural unit (2). From the viewpoint of obtaining good charge-transporting property, the content of the structural unit (2) is preferably 50 mol% or more, more preferably 75 mol% or more, and further preferably 90 mol% based on the total amount of the trivalent or higher valent structural unit. The upper limit of the content of the structural unit (2) is 100 mol%.

From the viewpoint of obtaining an organic layer having excellent solvent resistance, the content of the trivalent or higher valent structural unit contained in the charge-transporting polymer is preferably 1 mol% or more, more preferably 5 mol% or more, and further preferably 10 mol% or more based on all the structural units. In addition, from the viewpoint of suppressing an increase in viscosity and satisfactorily synthesizing the charge-transporting polymer or the viewpoint of obtaining sufficient charge-transporting property, the content of the trivalent or higher valent structural unit is preferably 50 mol% or less, more preferably 40 mol% or less, further preferably 30 mol% or less, and particularly preferably 20 mol% or less.

The charge-transporting polymer may comprise a monovalent structural unit (for example, the structural unit (4)) in addition to the structural unit (3). From the viewpoint of obtaining good charge-transporting property, the content of the structural unit (3) is preferably 85 mol% or more, more preferably 90 mol% or more, and further preferably 95 mol% or more based on the total amount of the monovalent structural unit. The upper limit of the content of the structural unit (3) is 100 mol%.

From the viewpoint of curability and solubility of the charge-transporting polymer and the viewpoint of improvement of the characteristics of the organic electronics element, the content of the monovalent structural unit contained in the charge-transporting polymer is preferably 5 mol% or more, more preferably 10 mol% or more, and further preferably 15 mol% or more based on all structural units. In addition, from the viewpoint of obtaining sufficient charge-transporting property, the content of the monovalent structural unit is preferably 60 mol% or less, more preferably 55 mol% or less, and further preferably 50 mol% or less.

The charge-transporting polymer may comprise an optional structural unit. From the viewpoint of obtaining a sufficient effect of the structural units (1) to (3), the content of the optional structural unit is preferably 50 mol% or less, more preferably 30 mol% or less, further preferably 20 mol% or less, and particularly preferably 10 mol% or less or 5 mol% or less based on all structural units. The lower limit of the content of the optional structural unit is 0 mol%. That is, the charge-transporting polymer may not comprise an optional structural unit.

The charge-transporting polymer may comprise a structural unit having a substituent containing a substituted or unsubstituted saturated hydrocarbon chain. Examples of the substituted or unsubstituted saturated hydrocarbon chain include a substituted or unsubstituted alkylene chain (*-(CH₂)ₙ-* (n is an integer greater than or equal to 2)). The substituent containing a substituted or unsubstituted alkylene chain may be a substituted or unsubstituted linear alkyl group (for example, *-CₙH_{2n + 1} (n is an integer greater than or equal to 2)), a monovalent group containing a substituted or unsubstituted linear alkylene group (for example, *-O-(CH₂)ₙ-OXT (n is an integer greater than or equal to 2, and OXT is an oxetane group optionally having a substituent)), and the like.

From the viewpoint of improving solubility, the charge-transporting polymer preferably comprises a structural unit having a substituent containing a substituted or unsubstituted saturated hydrocarbon chain (hereinafter, may be referred to as "structural unit C"). On the other hand, from the viewpoint of improving the life characteristics, it is preferable that the content of the structural unit C in the charge-transporting polymer is small. That is, when the charge-transporting polymer comprises the structural unit C, the content of the structural unit C is preferably 50 mol% or less based on all the structural units. In particular, it is preferable that the charge-transporting polymer does not comprise a structural unit C containing a substituted or unsubstituted saturated hydrocarbon chain having 6 or more carbon atoms (for example, a structural unit C having a substituent containing a substituted or unsubstituted alkylene chain (*-(CH₂)ₙ-* (n is an integer greater than or equal to 6))), or when the charge-transporting polymer comprises the structural unit C, the content of the structural unit C is preferably 30 mol% or less, more preferably 20 mol% or less, and further preferably 10 mol% or less based on all the structural units. In all the structural units contained in the charge-transporting polymer, it is more preferably that the content of the structural unit C containing a substituted or unsubstituted saturated hydrocarbon chain having 5 or more carbon atoms is in the above range, further preferably that the content of the structural unit C containing a substituted or unsubstituted hydrocarbon chain having 4 or more carbon atoms is in the above range, and particularly preferably that the content of the structural unit C containing a substituted or unsubstituted hydrocarbon chain having 3 or more carbon atoms is in the above range.

In particular, from the viewpoint of obtaining more excellent life characteristics, in the charge-transporting polymer, the monovalent structural unit does not comprise a structural unit C containing a substituted or unsubstituted saturated hydrocarbon chain having 6 or more carbon atoms (for example, a structural unit C having a substituent containing a substituted or unsubstituted alkylene chain (*-(CH₂)ₙ-* (n is an integer greater than or equal to 6))), or when the charge-transporting polymer comprises the structural unit C, the content of the structural unit C is preferably 15 mol% or less, more preferably 10 mol% or less, and further preferably 5 mol% or less based on the total amount of the monovalent structural units. In the monovalent structural units, it is more preferably that the content of the structural unit C containing a substituted or unsubstituted saturated hydrocarbon chain having 5 or more carbon atoms is in the above range, further preferably that the content of the structural unit C containing a substituted or unsubstituted hydrocarbon chain having 4 or more carbon atoms is in the above range, and particularly preferably that the content of the structural unit C containing a substituted or unsubstituted hydrocarbon chain having 3 or more carbon atoms is in the above range.

As for the ratio (molar ratio) of the contents of the divalent structural unit, the trivalent or higher valent structural unit, and the monovalent structural unit contained in the charge-transporting polymer, considering the balance of effects of each structural unit, the divalent structural unit: the trivalent or higher valent structural unit: the monovalent structural unit is preferably 100: 5 to 70: 50 to 150, more preferably 100: 10 to 60: 60 to 135, and further preferably 100: 15 to 50:80 to 120.

The content of the structural units can be determined using the usage amount of the monomer corresponding to each structural unit used for synthesizing the charge-transporting polymer. In addition, the ratio of the structural units can be calculated as an average value by using the integrated value of the spectrum derived from each structural unit in the ¹H NMR spectrum of the charge-transporting polymer. Because of the simplicity, when the usage amount is clear, it is preferable to adopt the value obtained using the usage amount.

### (Number average molecular weight)

The number average molecular weight of the charge-transporting polymer can be appropriately adjusted in consideration of solubility in a solvent, film-forming property, and the like. From the viewpoint of excellent charge-transporting property, the number average molecular weight is preferably 500 or more, more preferably 1,000 or more, further preferably 2,000 or more, and particularly preferably 5,000 or more. In addition, from the viewpoint of maintaining good solubility in a solvent and facilitating the preparation of a liquid composition, the number average molecular weight is preferably 1,000,000 or less, more preferably 100,000 or less, further preferably 50,000 or less, and particularly preferably 30,000 or less.

### (Weight average molecular weight)

The weight average molecular weight of the charge-transporting polymer can be appropriately adjusted in consideration of solubility in a solvent, film-forming property, and the like. From the viewpoint of excellent charge-transporting property, the weight average molecular weight is preferably 1,000 or more, more preferably 5,000 or more, and further preferably 10,000 or more. In addition, from the viewpoint of maintaining good solubility in a solvent and facilitating the preparation of a liquid composition, the weight average molecular weight is preferably 1,000,000 or less, more preferably 700,000 or less, further preferably 400,000 or less, and particularly preferably 100,000 or less.

The number average molecular weight and the weight average molecular weight can be measured by gel permeation chromatography (GPC) using a standard polystyrene calibration curve. The measurement conditions may be, for example, the conditions described in the examples.

### (Structural example of charge-transporting polymer)

The charge-transporting polymer comprises a divalent structural unit including the structural unit (1), a trivalent or higher valent structural unit including the structural unit (2), and a monovalent structural unit including the structural unit (3). The trivalent or higher valent structural unit forms the branched portion of the charge-transporting polymer, and the monovalent structural unit forms the end portion of the charge-transporting polymer.

According to a preferred embodiment, the charge-transporting polymer comprises a branched structure having at least one structural unit (2) and three or more structural units (1) bound to the one structural unit (2). Preferably, the charge-transporting polymer comprises a multi-branched structure having one structural unit (2) and three or more structural units (1) bound to the one structural unit (2), wherein each of the three or more structural units (1) further has at least one different structural unit (2) bound to the structural unit (1) and two or more different structural units (1) bound to the one different structural unit (2).

Examples of the structure contained in the charge-transporting polymer include the following. In the structure, "L" represents a divalent structural unit, "B" represents a trivalent or higher valent structural unit, and "T" represents a monovalent structural unit. In the following structure, the plurality of Ls may be the same structural unit or different structural units from each other. The same applies to B and T. Note that, the charge-transporting polymer is not limited to those having the following structures.

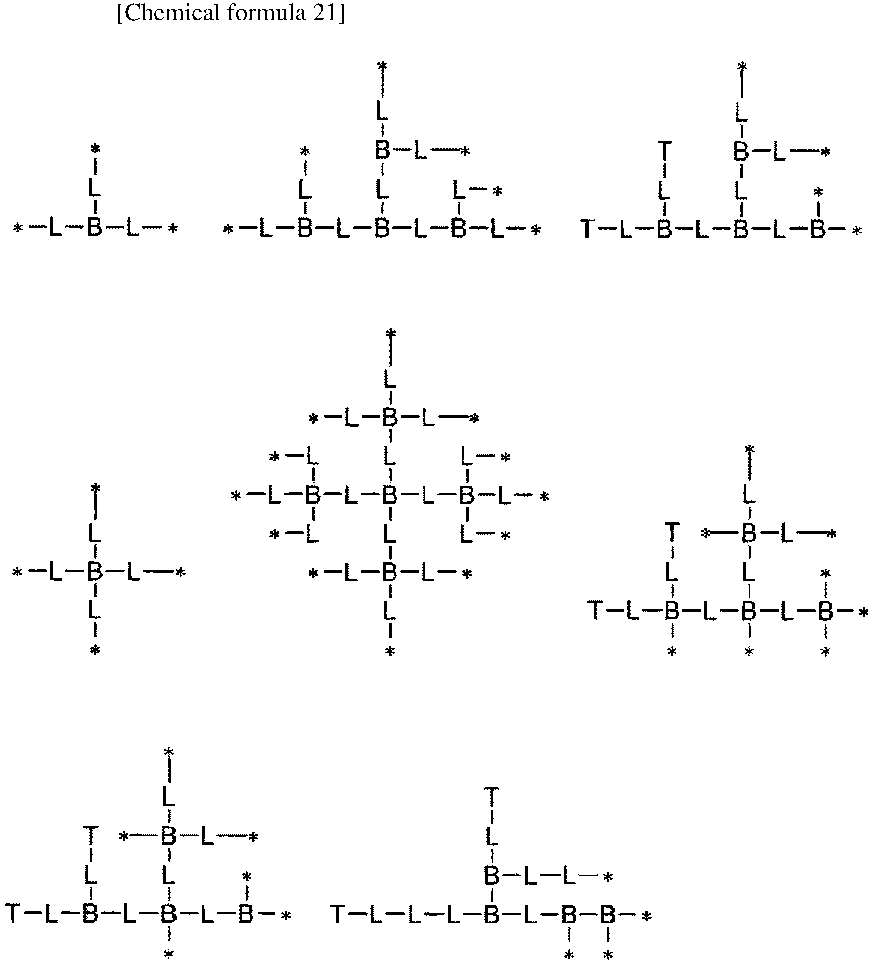

### (Application and the like of charge-transporting polymer)

The charge-transporting polymer can adjust the HOMO level to an appropriate level by having the structural unit (1), and has excellent solubility and durability by having the structural unit (2). In addition, because the charge-transporting polymer has the structural unit (3) of a specific content, the polymer is also excellent in curability and life characteristics. Organic electronics materials containing the above charge-transporting polymer can be preferably used in, for example, a hole transport layer of an organic EL element. Because good solubility can be obtained, the organic electronics material is preferably used by being dissolved in a solvent containing at least one solvent selected from a group consisting of aromatic ethers and aromatic halides.

### <Method for preparing charge-transporting polymer>

One embodiment of the present invention relates to a method for preparing a charge-transporting polymer, which prepares a charge-transporting polymer used in the organic electronics material. The method includes making a monomer mixture react in a solvent containing an aromatic ether, wherein the monomer mixture contains a bifunctional monomer having a structural unit represented by the above formula (1), at least one trifunctional or tetrafunctional functional monomer selected from a group consisting of a trifunctional monomer having a structural unit represented by the above formula (2-1) and a tetrafunctional monomer having a structural unit represented by the above formula (2-2), and a monofunctional monomer having a structural unit represented by the above formula (3) in an amount of 85 to 100 mol% based on the total amount of the monofunctional monomer. The method for preparing a charge-transporting polymer may further include optional steps such as preparing monomers, mixing the monomer mixture with a solvent, adding a catalyst, cleaning the charge-transporting polymer, and the like.

In the present disclosure, the "monomer having a structural unit represented by formula (X)" may be referred to as "monomer (X)". In addition, "at least one monomer selected from a group consisting of a monomer having a structural unit represented by formula (Y-1) and a monomer having a structural unit represented by formula (Y-2)" may be referred to as "monomer (Y)".

### [Monomer mixture]

The monomer mixture contains at least the monomer (1), the monomer (2), and the monomer (3). The content of the monomer (3) is 85 to 100 mol% based on the total amount of the monofunctional monomer. The monomer mixture may further contain an optional monomer different from the monomers (1) to (3). For example, the monomer mixture may further contain at least one monofunctional monomer selected from a group consisting of a monofunctional monomer having a structural unit represented by formula (4-1) and a monofunctional monomer having a structural unit represented by formula (4-2).

### (Monomer (1))

The monomer (1) contains one structural unit (1) in the molecule. The monomer (1) can be used to introduce the structural unit (1) into the charge-transporting polymer. The description of the structural unit (1) can be applied to the structural unit (1) contained in the monomer (1). The monomer (1) is a bifunctional monomer having two reactive functional groups.

The monomer (1) is preferably a monomer represented by the following formula (1M) for example.

[Chemical formula 22] R-L-R (1 M)

In the formula, L represents the structural unit (1) and R independently represents a reactive functional group.

### (Monomer (2))

The monomer (2-1) is a trifunctional monomer containing one structural unit (2-1) in the molecule and having three reactive functional groups. The monomer (2-2) is a tetrafunctional monomer containing one structural unit (2-2) in the molecule and having four reactive functional groups. The monomer (2), which is one or more monomers selected from a group consisting of the monomer (2-1) and the monomer (2-2), can be used to introduce the structural unit (2) into the charge-transporting polymer. The description of the structural unit (2) can be applied to the structural unit (2) contained in the monomer (2).

The monomer (2-1) is preferably a monomer represented by the following formula (2-1M) for example.

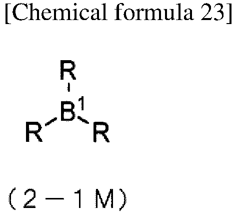

In the formula, B¹ represents the structural unit (2-1), and R independently represents a reactive functional group.

The monomer (2-2) is preferably a monomer represented by the following formula (2-2M) for example.

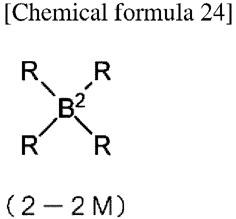

In the formula, B² represents the structural unit (2-2), and R independently represents a reactive functional group.

### (Monomer (3))

The monomer (3) contains one structural unit (3) in the molecule. The monomer (3) can be used to introduce the structural unit (3) into the charge-transporting polymer. The description of the structural unit (3) can be applied to the structural unit (3) contained in the monomer (3). The monomer (3) is a monofunctional monomer having one reactive functional group.

The monomer (1) is preferably a monomer represented by the following formula (3M) for example.

[Chemical formula 25] T-R (3 M)

In the formula, T represents the structural unit (3), and R represents a reactive functional group.

### (Monomer (4))

The monomer (4-1) is a monofunctional monomer containing one structural unit (4-1) in the molecule and having one reactive functional group. The monomer (4-2) is a monofunctional monomer containing one structural unit (4-2) in the molecule and having one reactive functional group. The monomer (4), which is one or more monomers selected from a group consisting of the monomer (4-1) and the monomer (4-2), can be used to introduce the structural unit (4) into the charge-transporting polymer. The description of the structural unit (4) can be applied to the structural unit (4) contained in the monomer (4).

The monomer (4-1) is preferably a monomer represented by the following formula (4-1M) for example.

[Chemical formula 26] T¹-R (4-1 M)

In the formula, T¹ represents the structural unit (4-1), and R represents a reactive functional group.

The monomer (4-2) is preferably a monomer represented by the following formula (4-2M) for example.

[Chemical formula 27] T²-R (4 - 2 M)

In the formula, T² represents the structural unit (4-2), and R represents a reactive functional group.

### (Reactive functional group)

Reactive functional groups are groups that can react with each other and form bonds between structural units. The bond is preferably a direct bond. The reactive functional group can be appropriately selected according to the desired reaction. For example, when the reaction is a Suzuki coupling reaction described later, the reactive functional group is preferably selected from a group consisting of a boronic acid group, a boronic acid ester group, and a halogen group.

An example of the monomer mixture is a mixture containing: a monomer (1) in which all the reactive functional groups are boronic acid groups or boronic acid ester groups; a monomer (2) in which all the reactive functional groups are halogen groups; and a monomer (3) in which the reactive functional group is a halogen group. Another example of the monomer mixture is a mixture containing: a monomer (1) in which all the reactive functional groups are halogen groups; a monomer (2) in which all the reactive functional groups are boronic acid groups or boronic acid ester groups; and a monomer (3) in which the reactive functional group is a boronic acid group or a boronic acid ester group. In these examples, when the monomer mixture further comprises a monomer (4), the monomer (4) preferably has the same reactive functional group as the monomer (3).

The monomer can be synthesized by a known method. In addition, these monomers can be obtained from, for example, Tokyo Chemical Industry Co., Ltd., Sigma-Aldrich Japan LLC, and the like.

### (Composition of monomer mixture)

The content of each monomer in the monomer mixture can follow the content of the structural unit corresponding to each monomer in the charge-transporting polymer. For example, similar to the content of the structural unit (3) in the charge-transporting polymer, the content of the monomer (3) in the monomer mixture is 85 to 100 mol% based on the monofunctional monomer. For example, similar to the content of the divalent structural unit in the charge-transporting polymer, the content of the bifunctional monomer in the monomer mixture is preferably 10 mol% or more based on all the monomers. That is, the description of the content (numerical range) of the structural units in the charge-transporting polymer can be used as description for the content (numerical range) of the monomer in the monomer mixture by substituting the charge-transporting polymer with the monomer mixture and the structural unit with the monomer.

### [Reaction of monomer mixture]

The reaction is preferably a coupling reaction, and the coupling reaction may be, for example, known reactions such as Suzuki coupling, Negishi coupling, Sonogashira coupling, Stille coupling, Buchwald-Hartwig coupling and the like. Suzuki coupling is, for example, a reaction that causes a cross-coupling reaction using a Pd catalyst between an aromatic boronic acid compound or an aromatic boronic acid ester compound and an aromatic halogen compound. According to Suzuki Coupling, the charge-transporting polymer can be easily prepared by bonding desired aromatic rings to each other.

In Suzuki coupling, for example, Pd compounds such as Pd (0) compounds and Pd (II) compounds, Ni compounds, Ru compounds and the like are used as the catalyst. Examples of the Pd compound include Pd compounds having a phosphine ligand, such as Pd(t-Bu₃P)₂(bis(tri-tert-butylphosphine) palladium (0)), Pd(t-Bu3P)4(tetrakis(tri-tert-butylphosphine) palladium (0)), Pd(PPh3)4(tetrakis(triphenylphosphine) palladium (0)), Pd(dppf)Cl₂([1,1'-bis(diphenylphosphino)ferrocene] palladium (II) dichloride), Pd(dppe)Cl₂([1,2-bis(diphenylphosphino) ethane] palladium (II) dichloride) and the like. In addition, a catalyst species generated by using tris(dibenzylideneacetone) dipalladium (0), palladium (II) acetate and the like as a precursor and mixing the precursor and a phosphine ligand in a reaction system can also be used. Examples of the phosphine ligand in this case include P(t-Bu)3(tris(t-butyl)phosphine), tributylphosphine, P(c-Hex)3(tricyclohexylphosphine) and the like.

The reaction solvent may be an organic solvent, and a mixed solvent of water and an organic solvent can be preferably used. Examples of the organic solvent include: an aromatic ether such as 1,2-dimethoxybenzene, 1,3-dimethoxybenzene, anisole, phenetol, 2-methoxytoluene, 3-methoxytoluene, 4-methoxytoluene, 2,3-dimethylanisole, 2,4-dimethylanisole and diphenyl ether; an aromatic hydrocarbon such as benzene, toluene, xylene, mesityrene, tetraline and diphenylmethane; tetrahydrofuran, acetone, acetonitrile, N,N-dimethylformamide and the like. In the reaction, the base includes: carbonates of alkali metals such as Na₂CO₃, K₂CO₃; hydroxides of alkali metals such as NaOH and KOH; phosphates of alkali metals such as K₃PO₃; water-soluble organic bases such as triethylamine, TMAH (tetramethylammonium hydroxide), TEAH (tetraethylammonium hydroxide); and the like. In addition, it is also possible to add a phase transfer catalyst to promote the reaction. Examples of the phase transfer catalyst include TBAB (tetrabutylammonium bromide), Aliquat 336 (registered trademark, manufactured by SIGMA-ALDRICH, a mixture of trioctylmethylammonium chloride and tricaprylmethylammonium chloride).

Suitable reaction solvents for obtaining the desired charge-transporting polymer may be solvents containing at least one selected from a group consisting of aromatic ethers and aromatic halides.

The aromatic ether preferably contains an aromatic ether represented by the following formula (A). When the reaction solvent contains an aromatic ether, the reaction solvent is preferably a mixed solvent containing water and an aromatic ether. Specifically, the aromatic ether is preferably anisole and/or phenetol, and more preferably anisole. When a solvent containing an aromatic ether is used, the charge-transporting polymer can be obtained efficiently and easily.

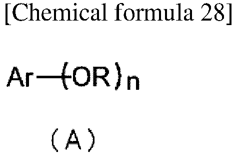

In the formula, Ar represents an aromatic hydrocarbon group, R represents a hydrocarbon group, and n represents an integer greater than or equal to 1.

As for the aromatic hydrocarbon group, the description regarding the aromatic hydrocarbon group in the structural unit (1) described above can be applied. Ar is preferably a benzene group or a naphthalene group, and more preferably a benzene group. The hydrocarbon group is preferably an aliphatic hydrocarbon group, and more preferably an alkyl group. The hydrocarbon group preferably has 1 to 8 carbon atoms, more preferably 1 to 6 carbon atoms, and further preferably 1 to 4 carbon atoms. Specifically, the hydrocarbon group may be an alkyl group, an ethyl group, a propyl group and the like. When Ar is a benzene group, n is preferably 1 to 3, more preferably 1 or 2, and further preferably 1.

When the reaction solvent is a mixed solvent containing an aromatic ether, the content of the aromatic ether is preferably 50% by mass or more, more preferably 60% by mass or more, further preferably 70% by mass or more, and particularly preferably 80% by mass or more based on the total amount of the reaction solvent. On the other hand, the content of the aromatic ether is preferably less than 100% by mass, more preferably 95% by mass or less, and further preferably 90% by mass or less based on the total amount of the reaction solvent.

The aromatic halide preferably contains an aromatic halide represented by the following formula (B). When the reaction solvent contains an aromatic halide, the reaction solvent is preferably a mixed solvent containing water and an aromatic halide. Specifically, the aromatic halide is preferably chlorobenzene, dichlorobenzene, and/or chloronaphthalene. When a solvent containing chlorobenzene is used, the charge-transporting polymer can be obtained efficiently and easily.

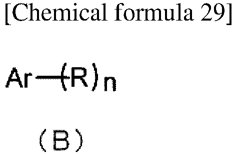

In the formula, Ar represents an aromatic hydrocarbon group, R represents a halogen atom, and n represents an integer greater than or equal to 1.

As for the aromatic hydrocarbon group, the description regarding the aromatic hydrocarbon group in the structural unit (1) described above can be applied. Ar is preferably a benzene group or a naphthalene group, and more preferably a benzene group. The halogen atom is preferably a chlorine atom. When Ar is a benzene group, n is preferably 1 to 3, more preferably 1 or 2, and further preferably 1.

When the reaction solvent is a mixed solvent containing an aromatic halide, the content of the aromatic halide is preferably 50% by mass or more, more preferably 60% by mass or more, further preferably 70% by mass or more, and particularly preferably 80% by mass or more based on the total amount of the reaction solvent. On the other hand, the content of the aromatic halide is preferably less than 100% by mass, more preferably 95% by mass or less, and further preferably 90% by mass or less based on the total amount of the reaction solvent.

### [Dopant]

The organic electronics material can contain any additive, for example, may further contain a dopant. The dopant is not particularly limited as long as it can exhibit a doping effect and improve charge-transporting property by being added to the organic electronics material. P-type doping is preferable for improving hole transportability, and n-type doping is preferable for improving electron transportability. In addition, one type of dopant may be added alone, or a plurality of types of dopants may be mixed and added.

Dopants used for p-type doping are electron-accepting compounds and may be a Lewis acid, a protonic acid, a transition metal compound, an ionic compound, a halogen compound, and a π-conjugated compound. Specifically, the Lewis acids may be FeCl₃, PF₅, AsFs, SbFs, BF₅, BCl₃, BBr₃, and the like; the protonic acid may be an inorganic acid such as HF, HCl, HBr, HNO₃, H2SO4, HClO₄ and the like, or an organic acid such as benzensulfonic acid, p-toluene sulfonic acid, dodecylbenzene sulfonic acid, polyvinyl sulfonic acid, methane sulfonic acid, trifluoromethane sulfonic acid, trifluoroacetic acid, 1-butane sulfonic acid, vinyl phenyl sulfonic acid, camphor sulfonic acid; the transition metal compound may be FeOCl, TiCl₄, ZrCl₄, HfCl₄, NbFs, AlCl₃, NbCls, TaCl₅, MoF₅; the ionic compound may be a salt having perfluoro anion such as tetrakis(pentafluorophenyl)boric acid ion, tris(trifluoromethane sulfonyl)methide ion, bis(trifluoromethane sulfonyl)imide ion, hexafluoroantimonic acid ion, AsF₆⁻(hexafluoroarsenic acid ion), BF₄⁻ (tetrafluoroboric acid ion), PF₆⁻(hexafluorophosphoric acid ion), a salt having conjugated base of the protonic acid as anion, and the like; the halogen compound may be Cl₂, Br2, I2, ICl, ICl₃, IBr, IF and the like; and the π-conjugated compound may be TCNE (tetracyanoethylene), TCNQ (tetracyanoquinodimethane) and the like.

The dopant used for n-type doping is an electron-donating compound and may be, for example, an alkali metal such as Li, Cs; an alkaline earth metal such as Mg, Ca; a salt of an alkali metal and/or an alkaline earth metal such as LiF, Cs₂CO₃; metal complexes; electron-donating organic compounds and the like.

In order to improve the solvent resistance of the organic layer, a compound that can act as a polymerization initiator for the polymerizable functional group may be used as the dopant.

### [Other optional component]

The organic electronics material may further contain a charge-transporting low molecular weight compound, other polymers and the like.

### [Content]

From the viewpoint of obtaining good charge-transporting property, the content of the charge-transporting polymer in the organic electronics material is preferably 50% by mass or more, more preferably 70% by mass or more, and further preferably 80% by mass or more based on the total mass of the organic electronics material. The upper limit of the content of the charge-transporting polymer is not particularly limited and may be 100% by mass. The content of the charge-transporting polymer may be, for example, 95% by mass or less or 90% by mass or less in consideration of containing an additive such as a dopant.

When a dopant is contained, from the viewpoint of improving the charge-transporting property of the organic electronics material, the content thereof is preferably 0.01% by mass or more, more preferably 0.1% by mass or more, and further preferably 0.5% by mass or more based on the total mass of the organic electronics material. In addition, from the viewpoint of maintaining good film forming property, the content of the dopant is preferably 50% by mass or less, more preferably 30% by mass or less, and further preferably 20% by mass or less based on the total mass of the organic electronics material.

### <Liquid composition>

The liquid composition according to an embodiment of the present invention contains the organic electronics material and a solvent. The liquid composition containing the solvent allows the organic layer to be easily formed by the coating method. The liquid composition can be used as an ink composition.

### [Solvent]

As the solvent, any solvent such as water, an organic solvent, or a mixed solvent thereof can be used. The organic solvent includes: alcohols such as methanol, ethanol and isopropyl alcohol; alkanes such as pentane, hexane and octane; cyclic alkanes such as cyclohexane; aromatic hydrocarbons such as benzene, toluene, xylene, mesitylene, tetraline and diphenylmethane; aliphatic ethers such as ethylene glycol dimethyl ether, ethylene glycol diethyl ether, propylene glycol-1-monomethyl ether acetate; aromatic ethers such as 1,2-dimethoxybenzene, 1,3-dimethoxybenzene, anisole, phenetol, 2-methoxytoluene, 3-methoxytoluene, 4-methoxytoluene, 2,3-dimethylanisole and 2,4-dimethylanisole; aliphatic esters such as ethyl acetate, n-butyl acetate, ethyl lactate and n-butyl lactate; aromatic esters such as phenyl acetate, phenyl propionate, methyl benzoate, ethyl benzoate, propyl benzoate and n-butyl benzoate; aromatic halides such as chlorobenzene, o-dichlorobenzene and 1-chloronaphthalene; amides such as N, N-dimethylformamide and N, N-dimethylacetamide; dimethylsulfoxide, tetrahydrofuran, acetone, chloroform, methylene chloride and the like. The liquid composition may contain one type of solvent alone, or may contain two or more types of solvents.

From the viewpoint of obtaining excellent solubility of the charge-transporting polymer, the liquid composition preferably contains a solvent comprising at least one selected from a group consisting of an aromatic ether and an aromatic halide. When the liquid composition contains a solvent containing an aromatic ether and/or an aromatic halide, the charge-transporting polymer can be easily dissolved in a solvent without introducing many linear alkylene groups or linear alkyl groups that may be introduced into the charge-transporting polymer to improve solubility. A low content of the linear alkylene group and the linear alkyl group in the charge-transporting polymer is preferable for improving the life characteristics of the organic electronics element. When the structural unit (1) is introduced into the charge-transporting polymer, the solubility of the charge-transporting polymer in common solvents such as aromatic hydrocarbons tends to decrease. However, when the liquid composition contains a solvent comprising an aromatic ether and/or an aromatic halide, good solubility can be easily obtained even when the charge-transporting polymer comprises the structural unit (1).

In a preferred example, the liquid composition preferably contains a solvent comprising an aromatic ether. The aromatic ether is preferably an aromatic ether represented by the above formula (A). Specifically, the aromatic ether is preferably anisole and/or phenetol, and more preferably anisole. When a solvent comprising an aromatic ether is used, the charge-transporting polymer can be efficiently and easily dissolved. When the solvent comprising an aromatic ether is a mixed solvent, the content of the aromatic ether in the mixed solvent is preferably 50% by mass or more, more preferably 70% by mass or more, and further preferably 90% by mass or more based on the total amount of the solvent. The solvent may be a solvent consisting of an aromatic ether only.

In another preferred example, the liquid composition preferably contains a solvent comprising an aromatic halide. The aromatic ether is preferably an aromatic ether represented by the above formula (B). Specifically, the aromatic halide is preferably chlorobenzene and/or dichlorobenzene, and more preferably chlorobenzene. When a solvent comprising an aromatic halide is used, the charge-transporting polymer can be efficiently and easily dissolved. When the solvent comprising an aromatic halide is a mixed solvent, the content of the aromatic halide in the mixed solvent is preferably 50% by mass or more, preferably 70% by mass or more, and further preferably 90% by mass or more based on the total amount of the solvent. The solvent may be a solvent consisting of an aromatic halide only.

### [Polymerization initiator]

The liquid composition preferably contains a polymerization initiator in order to make the oxetane group contained in the charge-transporting polymer react. As the polymerization initiator, known radical polymerization initiators, cationic polymerization initiators, anionic polymerization initiators and the like can be used. From the viewpoint that the liquid composition can be easily prepared, it is preferable to use a substance having both a function as a dopant and a function as a polymerization initiator. Such a substance may be the ionic compound described above.

### [Additive]

The liquid composition may further contain an additive as an optional component. The additive may be, for example, a polymerization inhibitor, a stabilizer, a thickener, a gelling agent, a flame retardant, an oxidation inhibitor, a reduction inhibitor, an oxidizing agent, a reducing agent, a surface modifier, an emulsifier, a defoamer, a dispersant, a surfactant and the like.

### [Content]

The content of the solvent in the liquid composition can be determined in consideration of application to various coating methods. For example, the content of the solvent is preferably such that the ratio of the charge-transporting polymer to the solvent is 0.1% by mass or more, more preferably 0.2% by mass or more, and further preferably 0.5% by mass or more. In addition, the content of the solvent is preferably such that the ratio of the charge-transporting polymer to the solvent is 20% by mass or less, more preferably 15% by mass or less, and further preferably 10% by mass or less.

### <Organic layer>

The organic layer according to an embodiment of the present invention is a layer formed using the organic electronics material or the liquid composition. The organic layer exhibits good charge-transporting property. By using the liquid composition, the organic layer can be satisfactorily and easily formed by a coating method. The coating method may be known methods including, for example, a spin coating method; a casting method; a dipping method; a plate printing method such as letterpress printing, intaglio printing, offset printing, flat plate printing, letterpress reversal offset printing, screen printing and gravure printing; a plateless printing method such as an inkjet method, and the like. When the organic layer is formed by the coating method, the layer of the liquid composition obtained after coating may be dried using a hot plate or an oven to remove the solvent.

Because the charge-transporting polymer contains the structural unit (3) having a polymerizable functional group, the polymerization reaction of the charge-transporting polymer can be made to proceed by light irradiation, heat treatment or the like to obtain a cured organic layer. By laminating the cured organic layers, it is possible to easily increase the number of layers of the organic electronics element.

From the viewpoint of improving the efficiency of charge transport, the thickness of the organic layer after drying or curing is preferably 0.1 nm or more, more preferably 1 nm or more, and further preferably 3 nm or more. In addition, from the viewpoint of reducing the electric resistance, the thickness of the organic layer is preferably 300 nm or less, more preferably 200 nm or less, and further preferably 100 nm or less.

### <Organic electronics element>

The organic electronics element according to an embodiment of the present invention has at least one organic layer described above. The organic electronics element may be an organic EL element such as an organic light emitting diode (OLED), an organic photoelectric conversion element, and an organic transistor. The organic electronics element preferably has a structure in which the organic layer is arranged between at least a pair of electrodes.

### <Organic electroluminescence element (organic EL element)>

The organic EL element according to an embodiment of the present invention has at least one organic layer described above. The organic EL element usually includes a light emitting layer, an anode, a cathode, and a substrate, and includes, if necessary, other functional layers such as a hole transporting layer like a hole injection layer and a hole transport layer, an electron transporting layer like an electron transport layer, and the like. Each layer may be formed by a vapour deposition method or a coating method. The organic EL element preferably has the organic layer as a light emitting layer or another functional layer, more preferably as another functional layer, and further preferably as at least one of a hole injection layer and a hole transport layer.

FIG. 1 is a schematic cross-sectional view showing an embodiment of the organic EL element. The organic EL element of FIG. 1 is a multi-layered element, and has a substrate 8, an anode 2, a hole injection layer 3 and a hole transport layer 6, a light emitting layer 1, an electron transport layer 7, an electron injection layer 5, and a cathode 4 in this order.

### [Light emitting layer]

As the material used for the light emitting layer, a light emitting material such as a low molecular weight compound, a polymer, or a dendrimer can be used. The polymer is preferable because of the high solubility in solvents and suitability for coating methods. The light emitting material includes fluorescent materials, phosphorescent materials, thermal activated delayed fluorescent materials (TADF) and the like.

### [Hole transporting layer]

The organic EL element preferably includes the organic layer as a hole transporting layer, and more preferably as at least one of a hole injection layer and a hole transport layer. As described above, these layers can be easily formed by using a liquid composition containing the organic electronics material.

When the organic EL element has the organic layer as a hole injection layer and further has a hole transport layer, a known material can be used for the hole transport layer. In addition, when the organic EL element has the organic layer as a hole transport layer and further has a hole injection layer, a known material can be used for the hole injection layer. The hole injection layer and the hole transport layer may be the organic layer.

When the hole transport layer is a cured organic layer, a light emitting layer can be easily formed on the upper layer by using an ink composition. In this case, the polymerization initiator may be contained in the organic layer which is a hole transport layer, or may be contained in the organic layer which is the lower layer of the hole transport layer.

### [Electron transporting layer]

The material used for the electron transporting layer such as an electron transport layer and an electron injection layer may be phenanthroline derivatives, bipyridine derivatives, nitro-substituted fluorene derivatives, diphenylquinone derivatives, thiopyrandioxide derivatives, condensed ring tetracarboxylic acid anhydrides of naphthalene, perylene and the like, carbodiimide, fluorenylidene methane derivatives, anthraquinodimethane and anthron derivatives, oxadiazole derivatives, thiadiazol derivatives, benzoimidazole derivatives, quinoxalin derivatives, aluminum complex and the like. In addition, the organic electronics material can also be used.

### [Cathode]

As the cathode material, for example, a metal or a metal alloy such as Li, Ca, Mg, Al, In, Cs, Ba, Mg/Ag, LiF, CsF is used.

### [Anode]

As the anode material, for example, a metal (for example, Au) or other conductive materials are used. Other materials may be, for example, oxides (eg. ITO: indium oxide/tin oxide), conductive polymers (eg. polythiophene-polystyrene sulfonic acid mixture (PEDOT:PSS)).

### [Substrate]

Glass, plastic and the like can be used as the substrate. The substrate is preferably transparent and preferably has flexibility. Quartz glass, resin film and the like are preferably used.

The resin film is preferably a light-transmitting resin film. When a resin film is used, the resin film may be coated with an inorganic substance such as silicon oxide or silicon nitride in order to suppress the permeation of water vapour, oxygen and the like.

### [Sealing]

The organic EL element may be sealed in order to reduce the influence of the outside air and prolong the life. As the material used for sealing, glass, a plastic film, or an inorganic substance such as silicon oxide or silicon nitride can be used, but the material is not limited thereto.

### [Emission color]

The emission color of the organic EL element is not particularly limited. The white organic EL element is preferable because it can be used for various lighting fixtures such as household lighting, vehicle interior lighting, backlights of clocks or liquid crystal, and the like.

### <Display element, lighting device, display device>

The display element according to an embodiment of the present invention includes the organic EL element. For example, by using the organic EL elements as elements corresponding to each pixel of red, green, and blue (RGB), color display elements can be obtained.

In addition, the lighting device according to an embodiment of the present invention includes the organic EL element. Further, the display device according to an embodiment of the present invention includes the lighting device and a liquid crystal element as a display part. For example, the display device may be a display device using the lighting device as a backlight and a known liquid crystal element as a display part, that is, may be a liquid crystal display device.

### <Example of embodiment>

Examples of preferred embodiments of the present invention are given below. Embodiments of the present invention are not limited to the following examples.
[1] An organic electronics material containing a charge-transporting polymer, wherein the charge-transporting polymer comprises
   a structural unit represented by the above formula (1),
   at least one structural unit selected from a group consisting of a structural unit represented by the above formula (2-1) and a structural unit represented by the above formula (2-2), and
   85 to 100 mol% of a structural unit represented by the above formula (3) based on the total amount of the monovalent structural unit.
[2] The organic electronics material according to the above [1], wherein the structural unit represented by the above formula (1) comprises at least one structural unit selected from a group consisting of a structural unit represented by the above formula (1b), a structural unit represented by the above formula (1c), a structure represented by the above formula (1d), and a structural unit represented by the above formula (1e).
[3] The organic electronics material according to the above [1] or [2], wherein the at least one structural unit selected from a group consisting of a structural unit represented by the above formula (2-1) and a structural unit represented by the above formula (2-2) comprises a structural unit represented by the above formula (2-1c), a structural unit represented by the above formula (2-1d), and a structural unit represented by the above formula (2-2b).
[4] The organic electronics material according to any one of the above [1] to [3], wherein the structural unit represented by the above formula (3) comprises a structural unit represented by the above formula (3a).
[5] The organic electronics material according to any one of the above [1] to [4], wherein the charge-transporting polymer further comprises at least one structural unit selected from a group consisting of a structural unit represented by the above formula (4-1) and a structural unit represented by the above formula (4-2).
[6] The organic electronics material according to the above [5], wherein the at least one structural unit selected from a group consisting of a structural unit represented by the above formula (4-1) and a structural unit represented by the above formula (4-2) comprises at least one structural unit selected from a group consisting of a structural unit represented by the above formula (4-1b) and a structural unit represented by the above formula (4-2b).
[7] A method for preparing a charge-transporting polymer, which prepares a charge-transporting polymer used in the organic electronics material according to any one of [1] to [6], wherein
   the method includes making a monomer mixture react in a solvent containing an aromatic ether, the monomer mixture containing a bifunctional monomer having the structural unit represented by the above formula (1), at least one trifunctional or tetrafunctional monomer selected from a group consisting of a trifunctional monomer having a structural unit represented by the above formula (2-1) and a tetrafunctional monomer having a structural unit represented by the above formula (2-2), and 85 to 100 mol% of a monofunctional monomer having a structural unit represented by the above formula (3) based on the total amount of the monofunctional monomer.
[8] A liquid composition containing the organic electronics material according to any one of the above [1] to [6] and a solvent.
[9] The liquid composition according to the above [8], wherein the solvent comprises an aromatic ether.
[10] An organic layer formed using the organic electronics material according to any one of the above [1] to [6] or the liquid composition according to above [8] or [9].
[11] An organic electronics element including the organic layer according to the above [10].
[12] An organic electroluminescence element including the organic layer according to the above [10].
[13] An organic electroluminescence element including the organic layer according to the above [10] as a hole injection layer or a hole transport layer.
[14] A display element including the organic electroluminescence element according to the above [12] or [13].
[15] A lighting device including the organic electroluminescence element according to the above [12] or [13].
[16] A display device including the lighting device according to the above [15] and a liquid crystal element as a display part.

### Examples

Embodiments of the present invention are specifically described with reference to examples. Embodiments of the present invention are not limited to the following examples.

### <Preparation of charge-transporting polymer>

### [Preparation of Pd catalyst]

Tris(dibenzylideneacetone) dipalladium (73.2 mg, 80 µmol) was weighed into a sample tube at room temperature in a glove box under a nitrogen atmosphere, anisole (15 mL) was added, and the mixture was stirred for 30 minutes. Similarly, tris(t-butyl) phosphine (129.6 mg, 640 µmol) was weighed into a sample tube, anisole (5 mL) was added, and the mixture was stirred for 5 minutes. These solutions were mixed and stirred at room temperature for 30 minutes, and the catalyst solution (hereinafter referred to as "Pd catalytic solution") was obtained. In the preparation of the Pd catalyst, all solvents were used after being degassed by nitrogen bubbles for at least 30 minutes.

### [Preparation of charge-transporting polymer]

Charge-transporting polymers 1 to 22 were prepared according to the following. The monomers used are shown in Table 1.

### [Table 1-1]

**Table 1**

| Bifunctional monomer | Trifunctional or tereafunctional monomer | Monofunctional monomer (3) | Monofunctional monomer (4) | Monofunctional monomer |
|---|---|---|---|---|
| 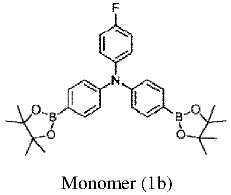 | 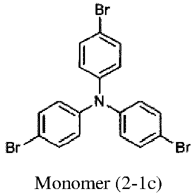 | 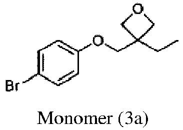 | 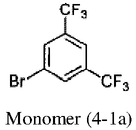 | 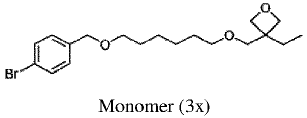 |
| 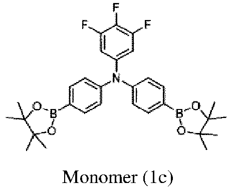 | 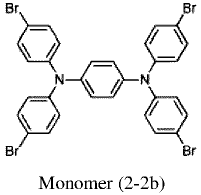 | 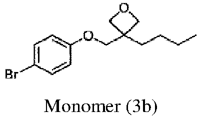 | 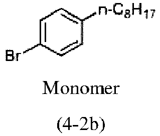 | 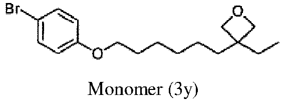 |

### [Table 1-2]

**Connected to Table 1**

| Bifunctional monomer | Trifunctional or tereafunctional monomer | Monofunctional monomer (3) | Monofunctional monomer (4) | Monofunctional monomer |
|---|---|---|---|---|
| 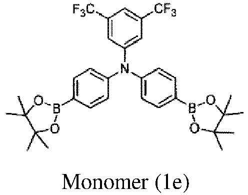 | | | | 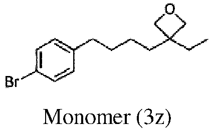 |
| 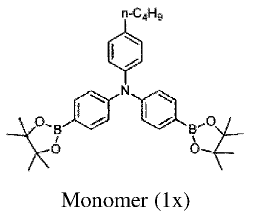 | | | | |

### (Charge-transporting polymer 1)

In a three-necked round bottom flask, monomer (1b) (5.0 mmol), monomer (2-1c) (2.0 mmol), monomer (3a) (2.0 mmol), monomer (4-1b) (2.0 mmol), methyltri-n-octyl ammonium chloride ("Alicoat 336" of Alfa Aesar) (0.04 g), an aqueous potassium hydroxide solution of 3M (7.79 g), and anisole (53 mL) were added, and the Pd catalytic solution (1.0 mL) was further added and mixed. The obtained mixture was heated to reflux for 2 hours. All operations till now were performed under a nitrogen stream. In addition, all the solvents were used after being degassed by nitrogen bubbling for 30 minutes or more.

After completion of the reaction, the organic layer was washed with water and poured into methanol-water (9:1). The resulting precipitate was collected by suction filtration and washed with methanol-water (9:1). The obtained precipitate was dissolved in toluene and reprecipitated from methanol. The obtained precipitate was collected by suction filtration and dissolved in toluene, a metal adsorbent ("Triphenylphosphine, polymer-bound on styrene-divinylbenzene copolymer" manufactured by Strem Chemicals, 200 mg per 100 mg of precipitate) was added, and the mixture was stirred at 80°C for 2 hours. After completion of the stirring, the metal adsorbent and the insoluble matter were removed by filtration, and then reprecipitation from methanol was performed. The resulting precipitate was collected by suction filtration and washed with methanol. The obtained precipitate was vacuum dried to obtain charge-transporting polymer 1. The charge-transporting polymer 1 had a number average molecular weight of 15,092 and a weight average molecular weight of 56,449.

The number average molecular weight and the weight average molecular weight were measured by GPC (polystyrene conversion) using tetrahydrofuran (THF) as the eluent. The measurement conditions are as follows.
Equipment: high performance liquid chromatograph Prominence of Shimadzu Corporation
   liquid transfer pump (LC-20AD)
   degassing unit (DGU-20A)
   autosampler (SIL-20AHT)
   column oven (CTO-20A)
   PDA detector (SPD-M20A)
   differential refractometer (RID-20A)
Column: Gelpack (registered trademark)
   GL-A160S (serial number: 686-1J27)
   GL-A150S (serial number: 685-1J27) of Hitachi Kasei Co., Ltd.
Eluent: tetrahydrofuran (THF) (for HPLC, containing stabilizer) of Fujifilm Wako Pure Chemical Industries, Ltd.
Flow velocity: 1 mL / min
Column temperature: 40°C
Detection wavelength: 254 nm
Molecular weight standard substance: PStQuick A/B/C of Tosoh Corporation

### (Charge-transporting polymer 2 to 22)

Charge-transporting polymers 2 to 22 were prepared in the same manner as charge-transporting polymer 1 except that the monomers used were changed to the monomers shown in Table 2.

Table 2 shows the monomer ratios of the charge-transporting polymers 1 to 22, the content of the monomer (3), the number average molecular weight, and the weight average molecular weight.

### [Table 2]

**Table 2**

| Charge-tra nsporting polymer | Monomer | | | | | | (3)/ (monofuncti onal polymer) | Mn | Mw | |
|---|---|---|---|---|---|---|---|---|---|---|
| | Bifunction al | | Trifunctio nal/ tetrafuncti onal | Monofunct ional (3) | Monofunct ional (4) | Monofun ctional | | | | |
| 1 | (1b) | | (2-1c) | (3a) | (4-1b) | | 50 | 15,092 | 56,449 | Comparative example |
| | 50 | | 20 | 20 | 20 | | | | | |
| 2 | (1b) | | (2-1c) | (3a) | (4-1b) | | 85 | 11,944 | 66,211 | Example |
| | 50 | | 20 | 34 | 6 | | | | | |
| 3 | (1b) | | (2-1c) | (3a) | | | 100 | 11,321 | 53,470 | Example |
| | 50 | | 20 | 40 | | | | | | |
| 4 | (1b) | | (2-1c) | (3a) | (4-2b) | | 50 | 12,319 | 59,557 | Comparative example |
| | 50 | | 20 | 20 | 20 | | | | | |
| 5 | (1b) | | (2-1c) | (3a) | (4-2b) | | 85 | 11,956 | 78,197 | Example |
| | 50 | | 20 | 34 | 6 | | | | | |
| 6 | (1b) | (1c) | (2-1c) | (3a) | (4-1b) | | 85 | 12,560 | 61,200 | Example |
| | 30 | 20 | 20 | 34 | 6 | | | | | |
| 7 | (1b) | (1c) | (2-1c) | (3a) | | | 100 | 13,180 | 42,254 | Example |
| | 30 | 20 | 20 | 40 | | | | | | |
| 8 | (1b) | (1e) | (2-1c) | (3a) | (4-1b) | | 50 | 20,713 | 50,432 | Comparative example |
| | 30 | 20 | 20 | 20 | 20 | | | | | |
| 9 | (1b) | (1e) | (2-1c) | (3a) | (4-1b) | | 85 | 19,500 | 59,300 | Example |
| | 30 | 20 | 20 | 34 | 6 | | | | | |
| 10 | (1b) | (1e) | (2-1c) | (3a) | | | 100 | 19,467 | 48,711 | Example |
| | 30 | 20 | 20 | 40 | | | | | | |
| 11 | (1b) | (1e) | (2-1c) | (3a) | (4-2b) | | 50 | 17,431 | 44,861 | Comparative example |
| | 30 | 20 | 20 | 20 | 20 | | | | | |
| 12 | (1b) | (1e) | (2-1c) | (3a) | (4-2b) | | 85 | 18,320 | 43,000 | Example |
| | 30 | 20 | 20 | 34 | 6 | | | | | |
| 13 | (1b) | | (2-2b) | (3a) | (4-1b) | | 50 | 14,449 | 40,537 | Comparative example |
| | 40 | | 10 | 20 | 20 | | | | | |
| 14 | (1b) | | (2-2b) | (3a) | (4-1b) | | 85 | 12,605 | 45,000 | Example |
| | 40 | | 10 | 34 | 6 | | | | | |
| 15 | (1b) | | (2-2b) | (3a) | | | 100 | 11,736 | 50,375 | Example |
| | 40 | | 10 | 40 | | | | | | |
| 16 | (1b) | | (2-2b) | (3a) | (4-2b) | | 50 | 11,178 | 39,821 | Comparative example |
| | 40 | | 10 | 20 | 20 | | | | | |
| 17 | (1b) | | (2-2b) | (3a) | (4-2b) | | 85 | 11,923 | 42,821 | Example |
| | 40 | | 10 | 34 | 6 | | | | | |
| 18 | (1b) | | (2-1c) | | | (3x) | 0 | 23,200 | 54,600 | Comparative example |
| | 50 | | 20 | | | 40 | | | | |
| 19 | (1x) | | (2-1c) | | | (3x) | 0 | 17,800 | 85,500 | Comparative example |
| | 50 | | 20 | | | 40 | | | | |
| 20 | (1b) | | (2-1c) | | | (3y) | 0 | 17,100 | 45,600 | Comparative example |
| | 50 | | 20 | | | 40 | | | | |
| 21 | (1b) | | (2-1c) | | | (3z) | 0 | 19,700 | 61,700 | Comparative example |
| | 50 | | 20 | | | 40 | | | | |
| 22 | (1b) | | (2-1c) | (3b) | | | 100 | 18,800 | 44,600 | Example |
| | 50 | | 20 | 40 | | | | | | |

In Table 2, the values listed below each monomer number are the monomer ratios used in the synthesis. Further, in the column of "(3)/(monofunctional monomer)", the content (mol%) of the monomer (3) based on the total amount of the monofunctional monomer was listed.

### <Evaluation>

### [Solvent resistance evaluation]

According to the following, organic layers A1 to 22 were formed using charge-transporting polymers 1 to 22, and the solvent resistance (that is, the curability of the charge-transporting polymer) was evaluated by measuring the residual film ratio. The results are shown in Table 3.

### (Measurement of residual film ratio)

The following polymerization initiator (10 mg) was weighed into a 20 mL screw tube, chlorobenzene (10 mL) was added, and the mixture was stirred to obtain a polymerization initiator solution. The charge-transporting polymer (10 mg) and chlorobenzene (792 µL) were then added to a 9 mL screw tube to dissolve the charge-transporting polymer. Then, 101 µL of the polymerization initiator solution was added into the 9 mL screw tube and stirred to prepare an ink composition. The ink composition was filtered through a polytetrafluoroethylene (PTFE) filter (pore diameter 0.2 µm) and dropped onto a quartz substrate (length 22 mm × width 29 mm × thickness 0.7 mm), and a coating film was formed by a spin coater. Subsequently, heat curing was carried out at 200°C for 30 minutes in a nitrogen atmosphere to form an organic layer having a film thickness of 30 nm on the quartz substrate.

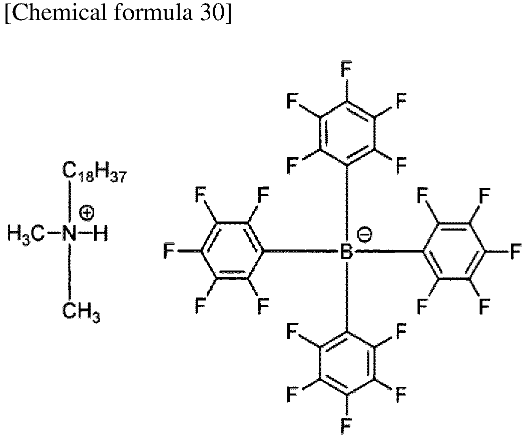

The absorbance A of the organic layer formed on the quartz substrate was measured using a spectrophotometer ("UV-2700" manufactured by Shimadzu Corporation). Subsequently, the quartz substrate was immersed in anisole (10 mL, 25°C.) for 10 minutes in an environment of 25°C in a manner that the organic layer after measurement was on the upper surface. The absorbance B of the organic layer after immersion in anisole was measured, and the residual film ratio was calculated from the absorbance A of the formed organic layer and the absorbance B of the organic layer after immersion in anisole using the following expression. The value at the maximum absorption wavelength of the organic layer was used as the value of absorbance. The larger the residual film ratio, the better the solvent resistance.

### [Mathematic expression 1]

Residual film ratio (%) = (absorbance B/absorbance A) × 100

### [HOMO level evaluation]

Organic layers B1 to 22 were formed using charge-transporting polymers 1 to 22 in the same manner as in (Measurement of residual film ratio), and the HOMO level was measured.

An atmospheric photoelectron spectrometer ("AC-5" manufactured by RIKEN Keiki Co., Ltd.) was used for the HOMO level measurement. The results are shown in Table 3.

### [Evaluation of charge-transporting property and heat resistance]

According to the following, HODs (hole-only devices) A1 to B22 were produced using charge-transporting polymers 1 to 22, and their conductivity and heat resistance were evaluated. The results are shown in Table 3.

The above polymerization initiator (10 mg) was weighed into a 20 mL screw tube, chlorobenzene (1 mL) was added, and the mixture was stirred to obtain a polymerization initiator solution. The charge-transporting polymer (30 mg) and chlorobenzene (782 µL) were then added to a 9 mL screw tube to dissolve the charge-transporting polymer. Then, 93 µL of the polymerization initiator solution was added to the 9 mL screw tube and stirred to prepare an ink composition. The ink composition was filtered with a polytetrafluoroethylene (PTFE) filter (pore diameter 0.2 µm) and then dropped onto a glass substrate (length 22 mm × width 29 mm × thickness 0.7 mm) on which ITO was patterned to a width of 1.6 mm, and a coating film was formed with a spin coater. Subsequently, heat curing was carried out at 200°C for 30 minutes in a nitrogen atmosphere to form an organic layer having a film thickness of 100 nm on a quartz substrate. The glass substrate was transferred to a vacuum vapour deposition machine, Al (100 nm) was deposited on the organic layer by the vapour deposition method, and sealing treatment was performed to produce HOD A.

Similar to the producing of HOD A, the ink composition was spin-coated on a glass substrate, on which ITO was patterned to a width of 1.6 mm, at a rotation speed of 3,000 min⁻¹ to form a coating film. Subsequently, heat curing was carried out at 200°C for 30 minutes in a nitrogen atmosphere, and additional heating was further carried out at 230°C for 30 minutes in a nitrogen atmosphere. After that, HOD B was produced in the same manner as HOD A was produced.

A voltage was applied to each of HOD A and B, and voltages A and B at a current density of 300 mA/cm² were measured. The smaller the values of the voltages A and B, the better the hole injection function. In addition, the voltage difference (voltage rise value) between the voltage A and the voltage B was obtained. The smaller the voltage difference, the better the heat resistance. The results are shown in Table 3.

Voltage A: value measured for HOD A (heated at 200°C for 30 minutes in a nitrogen atmosphere) at a current density of 300 mA/cm².

Voltage B: value measured for HOD B (heated at 200°C for 30 minutes in a nitrogen atmosphere, and then heated at 230°C for 30 minutes in a nitrogen atmosphere) at a current density of 300 mA/cm².

Voltage difference: value of voltage B (V) - voltage A (V).

### [Evaluation of element characteristics]

Organic EL elements 1 to 22 were produced using charge-transporting polymers 1 to 22 according to the following, and the drive voltage, luminous efficiency and emission lifetime were evaluated. The results are shown in Table 3.

### (Producing of organic EL element)

The above polymerization initiator (10 mg) was weighed into a 20 mL screw tube, chlorobenzene (10 mL) was added, and the mixture was stirred to obtain a polymerization initiator solution. The charge-transporting polymer (10 mg) and chlorobenzene (583 µL) were then added to a 9 mL screw tube to dissolve the charge-transporting polymer. Then, 309 µL of the polymerization initiator solution was added to the 9 mL screw tube and stirred to prepare an ink composition. The ink composition was filtered with a polytetrafluoroethylene (PTFE) filter (pore diameter 0.2 µm) and then dropped onto a glass substrate (length 22 mm × width 29 mm × thickness 0.7 mm) on which ITO was patterned to a width of 1.6 mm, and a coating film was formed with a spin coater. Then, the film was heated on a hot plate at 200°C for 30 minutes in a nitrogen atmosphere to form a hole injection layer (30 nm).

Poly TPD (Poly[N,N'-bis(4-butylphenyl)-N,N'-bis(phenyl)-benzidine] manufactured by Fujifilm Wako Pure Chemical Industries, Ltd.]) (10 mg) as a material for the hole transport layer and chlorobenzene (1794 µL) were added into a 9 mL screw tube and stirred to prepare an ink composition. The ink composition was filtered through a polytetrafluoroethylene (PTFE) filter (pore size 0.2 µm) and dropped onto the hole injection layer, and a coating film was formed by a spin coater. Then, the film was heated on a hot plate at 220°C for 30 minutes in a nitrogen atmosphere to form a hole transport layer (40 nm).

The glass substrate having the hole injection layer and the hole transport layer was transferred into a vacuum vapour deposition machine, and CBP:Ir (ppy)₃ (94:6, 30 nm), BAlq (10 nm), TPBi (30 nm), LiG (0.8 nm) and Al (100 nm) were deposited in this order by the vapour deposition method. Then, sealing treatment was performed to produce an organic EL element.

### (Evaluation of organic EL element)

When a voltage was applied to each organic EL element, green light emission was confirmed. The drive voltage and luminous efficiency at an emission brightness of 5,000 cd/m² and the emission lifetime (luminance half-time) at an initial emission brightness of 5,000 cd/m² were measured. The measurement results are shown in Table 3.

### [Table 3-1]

**Table 3**

| Charge- transporting polymer | Solvent resistance | | HOMO level | | Conductivity and heat resistance | | | | Element characteristics | | | | |
|---|---|---|---|---|---|---|---|---|---|---|---|---|---|
| | Organic layer A | Residual film rate [%] | Organic layer B | HOMO level (absolute value) [eV] | HOD A/B | A [V] | Voltage B [V] | Difference [V] | Organic EL element | Drive voltage [V] | Luminous efficiency [cd/A] | Emission lifetime [h] | |
| 1 | 1 | 85.2 | 1 | 5.50 | 1 | 1.3 | 1.3 | 0.0 | 1 | 10.1 | 28.9 | 256.0 | Comparative example |
| 2 | 2 | 95.8 | 2 | 5.42 | 2 | 1.4 | 1.4 | 0.0 | 2 | 7.9 | 33.5 | 300.0 | Example |
| 3 | 3 | 96.7 | 3 | 5.40 | 3 | 1.5 | 1.5 | 0.0 | 3 | 8.0 | 34.1 | 312.0 | Example |
| 4 | 4 | 89.7 | 4 | 5.40 | 4 | 1.3 | 1.3 | 0.0 | 4 | 9.8 | 27.1 | 261.0 | Comparative example |
| 5 | 5 | 96.3 | 5 | 5.40 | 5 | 1.4 | 1.4 | 0.0 | 5 | 7.8 | 33.3 | 314.0 | Example |
| 6 | 6 | 95.2 | 6 | 5.55 | 6 | 1.4 | 1.4 | 0.0 | 6 | 7.9 | 35.0 | 311.0 | Example |
| 7 | 7 | 96.1 | 7 | 5.50 | 7 | 1.5 | 1.5 | 0.0 | 7 | 8.1 | 24.7 | 308.0 | Example |
| 8 | 8 | 73.6 | 8 | 5.60 | 8 | 1.4 | 1.4 | 0.0 | 8 | 10.3 | 26.0 | 240.0 | Comparative example |
| 9 | 9 | 96.1 | 9 | 5.50 | 9 | 1.6 | 1.6 | 0.0 | 9 | 8.1 | 34.0 | 320.0 | Example |
| 10 | 10 | 95.2 | 10 | 5.50 | 10 | 1.6 | 1.6 | 0.0 | 10 | 7.9 | 33.0 | 309.0 | Example |
| 11 | 11 | 73.4 | 11 | 5.50 | 11 | 1.4 | 1.4 | 0.0 | 11 | 10.2 | 27.1 | 240.0 | Comparative example |
| 12 | 12 | 96.7 | 12 | 5.50 | 12 | 1.4 | 1.4 | 0.0 | 12 | 7.5 | 35.1 | 323.0 | Example |
| 13 | 13 | 61.4 | 13 | 5.40 | 13 | 1.3 | 1.3 | 0.0 | 13 | 11.0 | 29.3 | 220.0 | Comparative example |
| 14 | 14 | 96.0 | 14 | 5.30 | 14 | 1.4 | 1.4 | 0.0 | 14 | 11.1 | 28.7 | 212.0 | Example |
| 15 | 15 | 96.2 | 15 | 5.30 | 15 | 1.5 | 1.5 | 0.0 | 15 | 8.0 | 33.1 | 311.0 | Example |

### [Table 3-2]

**Connected to Table 3**

| Charge- transporting polymer | Solvent resistance | | HOMO level | | Conductivity and heat resistance | | | | Element characteristics | | | | |
|---|---|---|---|---|---|---|---|---|---|---|---|---|---|
| | Organic layer A | Residual film ratio [%] | Organic layer B | HOMO level (absolute value) [eV] | HOD A/B | A [V] | Voltage B [V] | Difference [V] | Organic EL element | Drive voltage [V] | Luminous efficiency [cd/A] | Emission lifetime [h] | |
| 16 | 16 | 86.2 | 16 | 5.30 | 16 | 1.3 | 1.3 | 0.0 | 16 | 10.6 | 29.0 | 240.0 | Comparative example |
| 17 | 17 | 96.7 | 17 | 5.30 | 17 | 1.4 | 1.4 | 0.0 | 17 | 7.8 | 32.0 | 319.0 | Example |
| 18 | 18 | 100.0 | 18 | 5.35 | 18 | 1.6 | 6.0 | 4.4 | 18 | 14.0 | 10.4 | 110.0 | Comparative example |
| 19 | 19 | 99.2 | 19 | 5.05 | 19 | 1.5 | 7.4 | 5.9 | 19 | 15.2 | 12.1 | 108.0 | Comparative example |
| 20 | 20 | 99.0 | 20 | 5.40 | 20 | 1.4 | 1.4 | 0.0 | 20 | 10.0 | 29.0 | 250.0 | Comparative example |
| 21 | 21 | 99.1 | 21 | 5.40 | 21 | 1.4 | 1.4 | 0.0 | 21 | 10.8 | 28.6 | 246.0 | Comparative example |
| 22 | 22 | 99.0 | 22 | 5.40 | 22 | 1.4 | 1.4 | 0.0 | 22 | 7.9 | 33.5 | 300.0 | Example |

As shown in Table 3, the organic layer according to the embodiment of the present invention has an appropriate energy level, is excellent in solvent resistance, and can improve the life characteristics of the organic electronics element.

### [Reference Signs List]

- 1: light emitting layer
- 2: anode
- 3: hole injection layer
- 4: cathode
- 5: electron injection layer
- 6: hole transport layer
- 7: electron transport layer
- 8: substrate

## Claims

1. An organic electronics material containing a charge-transporting polymer, wherein the charge-transporting polymer comprises
a structural unit represented by a formula (1) below,
at least one structural unit selected from a group consisting of a structural unit represented by a formula (2-1) below and a structural unit represented by a formula (2-2) below, and
85 to 100 mol% of a structural unit represented by a formula (3) below based on a total amount of a monovalent structural unit, 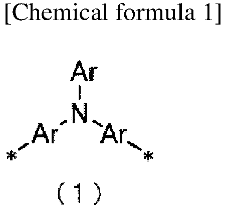 (in the formula, Ar independently represents a substituted or unsubstituted aromatic hydrocarbon group, and at least one Ar is an aromatic hydrocarbon group having a substituent comprising at least one selected from a group consisting of a fluoro group and a fluoroalkyl group) 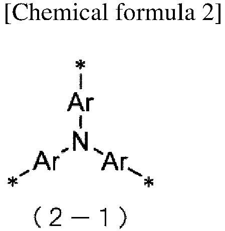 (in the formula, Ar independently represents a substituted or unsubstituted aromatic hydrocarbon group) 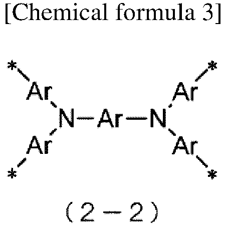 (in the formula, Ar independently represents a substituted or unsubstituted aromatic hydrocarbon group) 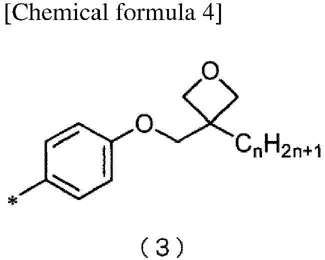 (in the formula, n represents an integer of 0 to 20).

2. The organic electronics material according to claim 1, wherein the structural unit represented by the formula (1) comprises at least one structural unit selected from a group consisting of a structural unit represented by a formula (1b) below, a structural unit represented by a formula (1c) below, a structure represented by a formula (1d) below, and a structural unit represented by a formula (1e) below,

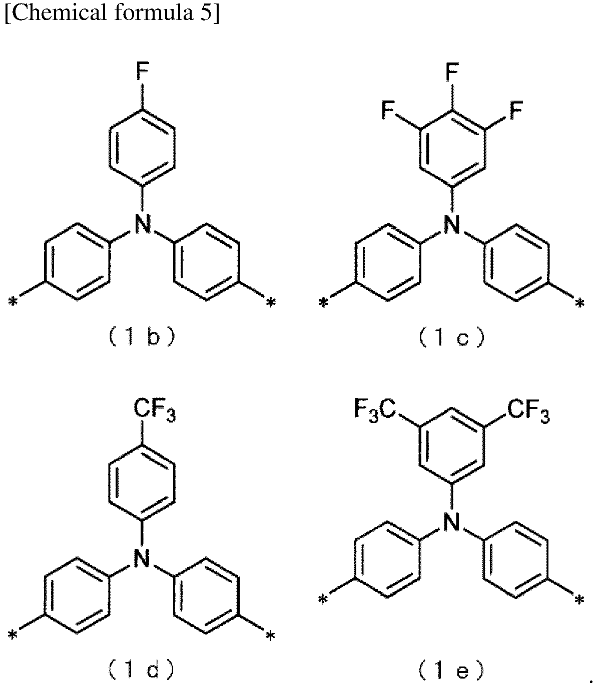

3. The organic electronics material according to claim 1 or 2, wherein the at least one structural unit selected from the group consisting of the structural unit represented by the formula (2-1) and the structural unit represented by the formula (2-2) comprises a structural unit represented by a formula (2-1c) below, a structural unit represented by a formula (2-1d) below, and a structural unit represented by a formula (2-2b) below,

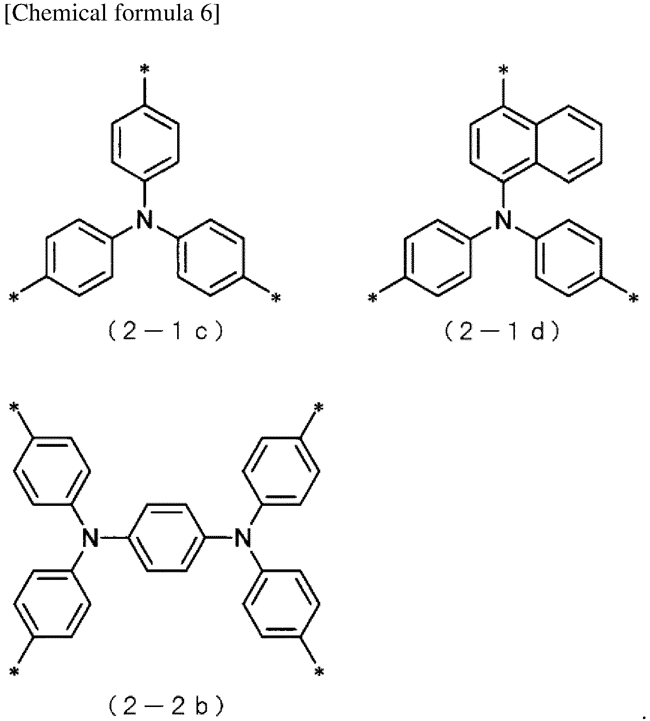

4. The organic electronics material according to any one of claims 1 to 3, wherein the structural unit represented by the formula (3) comprises a structural unit represented by a formula (3a) below,

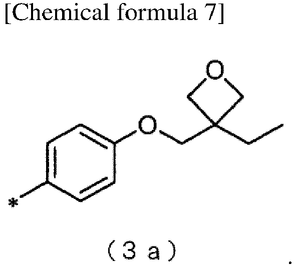

5. The organic electronics material according to any one of claims 1 to 4, wherein the charge-transporting polymer further comprises at least one structural unit selected from a group consisting of a structural unit represented by a formula (4-1) below and a structural unit represented by a formula (4-2) below, 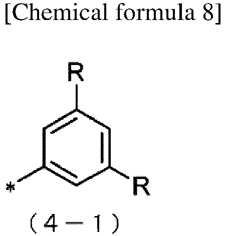 (in the formula, R independently represents a halogen group, a halogen-substituted alkyl group, a nitro group, a cyano group, a substituted or unsubstituted sulfo group, or a substituted or unsubstituted sulfino group) 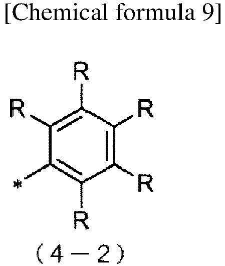 (in the formula, R independently represents a hydrogen atom or a linear alkyl group, and at least one R is a linear alkyl group).

6. The organic electronics material according to claim 5, wherein the at least one structural unit selected from the group consisting of the structural unit represented by the formula (4-1) and the structural unit represented by the formula (4-2) comprises at least one structural unit selected from a group consisting of a structural unit represented by a formula (4-1b) below and a structural unit represented by a formula (4-2b) below,

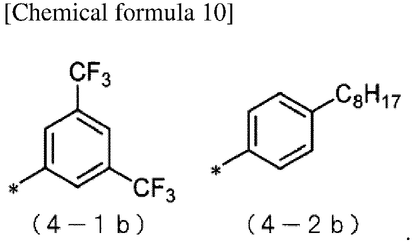

7. A method for preparing a charge-transporting polymer, which prepares a charge-transporting polymer used in the organic electronics material according to any one of claims 1 to 6, wherein
the method includes making a monomer mixture react in a solvent containing an aromatic ether, the monomer mixture containing a bifunctional monomer having the structural unit represented by the formula (1), at least one trifunctional or tetrafunctional monomer selected from a group consisting of a trifunctional monomer having the structural unit represented by the formula (2-1) and a tetrafunctional monomer having the structural unit represented by the formula (2-2), and 85 to 100 mol% of a monofunctional monomer having the structural unit represented by the formula (3) based on the total amount of the monofunctional monomer.

8. A liquid composition containing the organic electronics material according to any one of claims 1 to 6 and a solvent.

9. The liquid composition according to claim 8, wherein the solvent comprises an aromatic ether.

10. An organic layer formed using the organic electronics material according to any one of claims 1 to 6 or the liquid composition according to claim 8 or 9.

11. An organic electronics element including the organic layer according to claim 10.

12. An organic electroluminescence element including the organic layer according to claim 10.

13. An organic electroluminescence element including the organic layer according to claim 10 as a hole injection layer or a hole transport layer.

14. A display element including the organic electroluminescence element according to claim 12 or 13.

15. A lighting device including the organic electroluminescence element according to claim 12 or 13.

16. A display device including the lighting device according to claim 15 and a liquid crystal element as a display part.
